(19) Europäisches Patentamt / European Patent Office / Office européen des brevets

(11) **EP 2 092 651 B1**

(12) **FASCICULE DE BREVET EUROPEEN**

(45) Date de publication et mention de la délivrance du brevet:
**25.03.2020 Bulletin 2020/13**

(51) Int Cl.:
***H03M 13/11*** *(2006.01)*

(21) Numéro de dépôt: **07858681.5**

(22) Date de dépôt: **09.11.2007**

(86) Numéro de dépôt international:
**PCT/FR2007/052321**

(87) Numéro de publication internationale:
**WO 2008/059160 (22.05.2008 Gazette 2008/21)**

(54) **CODAGE ET DECODAGE D'UN SIGNAL DE DONNEES EN FONCTION D'UN CODE CORRECTEUR**

KODIERUNG UND DEKODIERUNG EINES DATENSIGNALS ALS FUNKTION EINES KORRIGIERENDEN CODES

ENCODING AND DECODING OF A DATA SIGNAL ACCORDING TO A CORRECTING CODE

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **13.11.2006 FR 0654864**

(43) Date de publication de la demande:
**26.08.2009 Bulletin 2009/35**

(73) Titulaire: **3G Licensing S.A.**
**2132 Luxembourg (LU)**

(72) Inventeurs:
• **DORE, Jean-Baptiste**
**38950 Saint Martin Le Vinoux (FR)**
• **HAMON, Marie-Hélène**
**35690 Acigne (FR)**
• **PENARD, Pierre**
**35000 Rennes (FR)**

(74) Mandataire: **Metroconsult Srl**
**Via Sestriere 100**
**10060 None (TO) (IT)**

(56) Documents cités:
EP-A- 1 511 177    EP-A- 1 626 505
EP-A- 1 648 091    US-A1- 2006 015 802

• YANG SUN, MARJAN KARKOOTI AND JOSEPH R. CAVALLARO: "HIGH THROUGHPUT, PARALLEL, SCALABLE LDPC ENCODER/DECODER ARCHITECTURE FOR OFDM SYSTEMS" INTERNET ARTICLE, [Online] octobre 2006 (2006-10), XP002440970 Extrait de l'Internet: URL:http://www.ece.rice.edu/~marjan/doc/Marjan_DCAS06.pdf> [extrait le 2007-07-04]
• PREDRAG RADOSAVLJEVIC, ALEXANDRE DE BAYNAST, MARJAN KARKOOTI, JOSEPH R. CAVALLARO: "HIGH-THROUGHPUT MULTI-RATE LDPC DECODER BASED ON ARCHITECTURE-ORIENTED PARITY CHECK MATRICES" INTERNET ARTICLE, [Online] septembre 2006 (2006-09), XP002440971 Extrait de l'Internet: URL:http://cmc.rice.edu/docs/docs/Rad2006Sep5HighThroug.pdf> [extrait le 2007-07-04]
• KARKOOTI M ET AL: "Semi-parallel reconfigurable architectures for real-time LDPC decoding" INFORMATION TECHNOLOGY: CODING AND COMPUTING, 2004. PROCEEDINGS. ITCC 2004. INTERNATIONAL CONFERENCE ON LAS VEGAS, NV, USA APRIL 5-7, 2004, PISCATAWAY, NJ, USA,IEEE, 5 avril 2004 (2004-04-05), pages 579-585, XP010696711 ISBN: 0-7695-2108-8

- ECHARD R ET AL: "THE PI-ROTATION LOW-DENSITY PARITY CHECK CODES" GLOBECOM'01. 2001 IEEE GLOBAL TELECOMMUNICATIONS CONFERENCE. SAN ANTONIO, TX, NOV. 25 - 29, 2001, IEEE GLOBAL TELECOMMUNICATIONS CONFERENCE, NEW YORK, NY : IEEE, US, vol. VOL. 2 OF 6, 25 novembre 2001 (2001-11-25), pages 980-984, XP001099251 ISBN: 0-7803-7206-9
- MANSOUR M M ET AL: "Memory-efficient turbo decoder architectures for LDPC codes" SIGNAL PROCESSING SYSTEMS, 2002. (SIPS '02). IEEE WORKSHOP ON OCT. 16-18, 2002, PISCATAWAY, NJ, USA,IEEE, 16 octobre 2002 (2002-10-16), pages 159-164, XP010616594 ISBN: 0-7803-7587-4
- MANSOUR M M ET AL: "High-throughput ldpc decoders" IEEE TRANSACTIONS ON VERY LARGE SCALE INTEGRATION (VLSI) SYSTEMS, IEEE SERVICE CENTER, PISCATAWAY, NJ, US, vol. 11, no. 6, décembre 2003 (2003-12), pages 976-996, XP011104612 ISSN: 1063-8210
- ZHONGFENG WANG ET AL: "Area efficient decoding of quasi-cyclic lowdensity parity check codes" ACOUSTICS, SPEECH, AND SIGNAL PROCESSING, 2004. PROCEEDINGS. (ICASSP '04). IEEE INTERNATIONAL CONFERENCE ON MONTREAL, QUEBEC, CANADA 17-21 MAY 2004, PISCATAWAY, NJ, USA,IEEE, 17 mai 2004 (2004-05-17), pages 49-52, XP010718835 ISBN: 0-7803-8484-9
- MANSOUR M M: "High-performance decoders for regular and irregular repeat-accumulate codes" GLOBAL TELECOMMUNICATIONS CONFERENCE, 2004. GLOBECOM '04. IEEE DALLAS, TX, USA 29 NOV.-3 DEC., 2004, PISCATAWAY, NJ, USA,IEEE, 29 novembre 2004 (2004-11-29), pages 2583-2588, XP010757993 ISBN: 0-7803-8794-5
- HE SHANBAO , ZHAO CHUNMING, JIANG MING: "Regular Low-Density Parity-Check codes based on shifted identity matrices" JOURNAL OF ELECTRONICS (CHINA), vol. 23, janvier 2006 (2006-01), XP008080885

**Description**

La présente invention concerne des codes correcteurs pour coder et décoder un signal de données notamment dans le domaine de la communication numérique et dans le domaine du stockage de données.

Plus particulièrement, elle a trait à des codes correcteurs LDPC ("Low Density Parity Check" en anglais) afin d'optimiser le décodage d'un signal de données codées.

Ces codes peuvent notamment être mis en œuvre par différents protocoles de communication tel que le protocole IEEE 802.11n destiné aux réseaux locaux sans fil (WLAN ("Wireless Local Area Network" en anglais)) à très haut débit ou encore tel que le protocole IEEE 802.16 (WIMAX Mobile ("World wide Interoperability Microwave Access" en anglais)).

Les systèmes de communication numérique offrant les meilleures qualités de transmission actuellement sont ceux où les données sont protégées par un codage de canal très performant et décodées itérativement par un décodeur à sortie pondérée.

Dans le domaine des transmissions numériques, et plus particulièrement lorsque le canal est de type radio électrique, des codes correcteurs d'erreurs ont pour fonction principale de lever des ambiguïtés apportées par le canal sur un signal transmis. Le gain en performance apporté par ces codes peut être affecté à la réduction de consommation de terminaux, à l'augmentation du volume d'informations transmis ou encore à une plus grande flexibilité dans la gestion de la taille des cellules de transmission.

Il est connu que les codes à contrôle de parité et faible densité LDPC ("Low Density Parity Check" en anglais) inventés en 1960 par Gallager offrent de très bonnes performances. Ils sont construits à partir d'une matrice de contrôle de parité pour obtenir des bits redondants, dits bits de parité, en fonction de bits de données relatifs au message à transmettre. Les bits de données et les bits de parité forment un mot de code inclus dans le signal codé à transmettre.

En particulier, les codes LDPC quasi cycliques (QC LDPC), dont la construction a été proposé dans le document de Marc P. C. Fossorier, intitulé "Quasi-cyclic Low-Density Parity -Check Codes From Circulant Permutation Matrices", IEEE Transaction on Information Theory, Août 2004, consiste à construire la matrice de contrôle de parités à partir de sous-matrices identités dont les colonnes sont permutées circulairement $\delta$ fois vers la gauche ou vers la droite. Cette forme de matrice permet une paramétrisation simple d'un code LDPC et permet également une réduction de la complexité de décodage du code grâce à sa structure quasi cyclique.

L'inconvénient majeur de cette construction est la difficulté d'encodage.

Pour pallier cet inconvénient la construction proposée dans le document de H.Jin, "Irregular repeat-accumulate codes", Proc. 2nd Int Symp Turbo codes and related topics, Brest, France, Septembre 2000 consiste en la division de la matrice de contrôle de parité H en deux sous-matrices, une matrice générée aléatoirement $H_1$ et une matrice de forme bi diagonale $H_2$ telles que $H = [H_1\ H_2]$. Les bits de parité sont déterminés en fonction des bits de données suivant la relation :

$$p^T = H_2^{-1}\ H_1\ C^T$$

avec $p^T$ et $C^T$ les transposées respectives du vecteur P contenant les bits de parité et du vecteur C contenant les bits de données.

L'inconvénient majeur de cette construction est l'irrégularité de la partie systématique du code représentée par la matrice de contrôle de parité aléatoire $H_1$, ayant pour conséquence un décodage parallèle non optimal. Ces codes sont appelés codes IRA ("Irregular Repeat-Accumulate" en anglais).

Pour pallier cet inconvénient, Kazunori Shimizu et al dans leur article "Partially-Parallel LDPC Decoder Based on High-Efficiency Message-Passing Algorithm", International Conference on Computer Design, San José, Californie, 02-05 Octobre 2005, pages 503-510, se sont intéressés à la construction de matrice de contrôle de parité régulière de forme quasi cyclique à partir de règles pour mettre en œuvre un décodage partiellement parallèle. Cependant, la restriction à une forme régulière de la matrice de contrôle de parité rend difficile l'encodage. En outre, l'algorithme de décodage relatif à la matrice de contrôle de parité n'est pas optimal en termes de rapidité de convergence vers le résultat et de ressources utiles induisant de multiples accès mémoire simultanés. L'article de Yang Sun et al., intitulé "High Throughput, parallel, scalable LDPC encoder/decoder architecture for OFDM systems" décrit un décodeur de codes LDPC avec une architecture parallèle et pipeline.

L'article de Frank Kienle et Norbert Wehn, intitulé "Design methodology for IRA codes", Proc.EDA Technofair Design Automation Conference Asia and South Pacific, 2004, décrit un procédé de construction de codes IRA dédiés à une architecture de decodeur mettant en ceuvre une parallelisation des taches de decodage. Dans cet article les auteurs proposent une construction fixe de la matrice de contrôle de parite pour eviter des conflits d'acces memoire caracteristiques d'une implementation en parallele de plusieurs processeurs. Cependant cette construction de code correcteur ne garantit pas une convergence optimale de l'algorithme de decodage. En outre, l'architecture du decodeur et la matrice de contrôle de parite telle que construite mettent en œuvre uniquement un ordonnancement parallele des taches de decodage. D'autres types d'ordonnancement ou de combinaisons d'ordonnancement ne sont pas consideres.

La presente invention remedie aux inconvenients evoques ci-dessus par les sujets des revendications.

D'autres caractéristiques et avantages de la présente invention apparaîtront plus clairement à la lecture de la description suivante de plusieurs réalisations de l'invention données à titre d'exemples non limitatifs, en référence aux dessins annexés correspondants dans lesquels :

- la figure 1 est un bloc-diagramme schématique d'un système de communication selon l'invention ;
- les figures 2a à 2e sont des représentations schématiques d'une matrice de contrôle de parité selon l'invention et de matrices qui la constituent;
- les figures 3 et 4 sont respectivement un bloc diagramme représentatif de l'architecture du dispositif décodeur selon l'invention et un diagramme temporel représentatif du fonctionnement du dispositif décodeur, selon un premier ordonnancement;
- la figure 5 est un algorithme de décodage relatif au premier ordonnancement de fonctionnement du dispositif décodeur selon l'invention;
- les figures 6, 7 et 8 sont des blocs-diagrammes schématiques représentatifs de trois décodeurs dans le dispositif décodeur selon l'invention;
- les figures 9 et 10 sont respectivement un diagramme temporel représentatif du fonctionnement du dispositif décodeur et un bloc diagramme représentatif de l'architecture associée du dispositif décodeur, selon un deuxième ordonnancement;
- les figures 11 et 12 sont respectivement un diagramme temporel représentatif du fonctionnement du dispositif décodeur et un bloc diagramme représentatif de l'architecture associée du dispositif décodeur, selon un troisième ordonnancement; et
- les figures 13 et 14 sont respectivement un diagramme temporel représentatif du fonctionnement du dispositif décodeur et un bloc diagramme représentatif de l'architecture associée du dispositif décodeur, selon un quatrième ordonnancement.

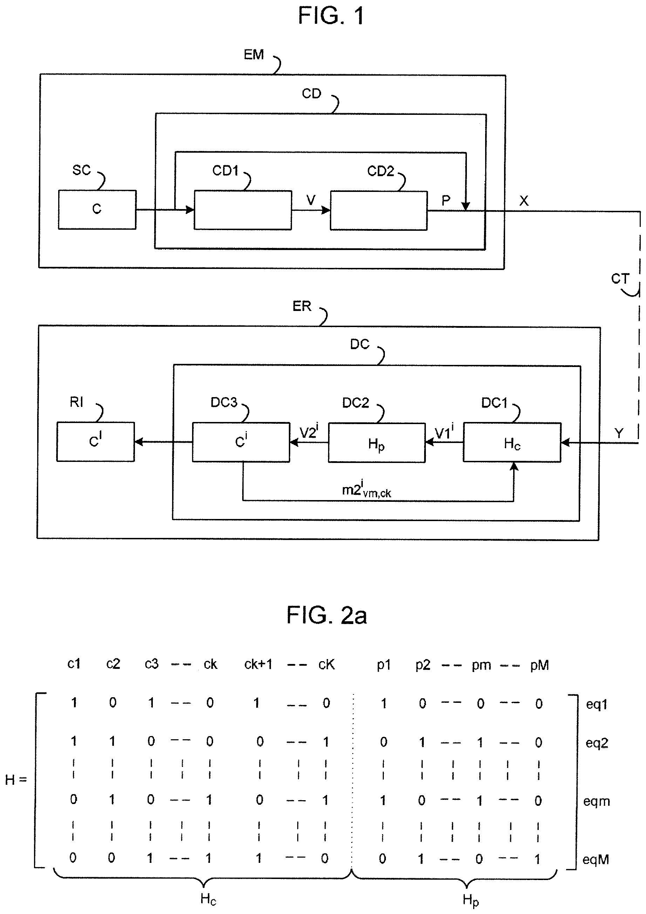

En référence à la figure 1, un système de communication selon l'invention comprend une entité émettrice EM et une entité réceptrice ER. L'entité émettrice émet des données via un canal de transmission CT vers l'entité réceptrice ER.

L'entité émettrice EM comprend une unité source SC qui génère des séquences de données chacune représentée par un vecteur de données C fourni à un dispositif encodeur CD. Le dispositif encodeur détermine un vecteur de parité P codé suivant un code LDPC généré à partir d'une matrice de contrôle de parité H décrite en relation avec la figure 2a. Les deux vecteurs C et P relatifs à une séquence de données forment un mot de code X. Des mots de code issus de séquences de données sont produits successivement par le dispositif encodeur pour constituer un signal de données codées.

Le signal de données codées contenant le mot de code X est transmis par l'entité émettrice EM via le canal de transmission CT à l'entité réceptrice ER. Cette dernière reçoit alors un signal codé de réception qui est déformé par rapport au signal codé de transmission. Le canal de transmission, dit également canal de propagation, peut être un canal aérien ou tout autre type de canal tel qu'un câble. A cause de perturbations du canal de transmission, chaque mot de code X subit des distorsions et devient un mot déformé Y inclus dans le signal de données reçu en entrée de l'entité réceptrice ER. Le canal de transmission se comporte comme une application déformante non déterministe entre le signal de données codées en entrée du canal et le signal de données codées en sortie du canal.

Afin de compenser les effets dus à la transmission, l'entité réceptrice ER comporte un dispositif décodeur DC qui détermine une meilleure estimation de chaque vecteur de données pour former un signal de code estimé comportant des vecteurs de données estimés.

Le dispositif décodeur DC décode de manière itérative chaque mot reçu Y suivant un algorithme de décodage contenant un code LDPC généré à partir de la matrice de contrôle de parité H. Le dispositif décodeur estime un vecteur sensiblement identique au vecteur de données C généré par la source SC de l'entité émettrice EM. Chaque signal de code contenant le vecteur estimé est fourni à un récepteur d'information RI, par exemple un dispositif de reproduction sonore doté d'un haut-parleur.

Un mot de code X en sortie de l'entité émettrice EM comprend $N = K + M$ variables dont K variables d'information ou de données c1 à cK formant un vecteur de données C, et M variables de parité p1 à pM formant un vecteur de parité P. Les variables sont des bits "0" ou "1". Le rendement R du code est le rapport $R = K/N$.

En référence à la figure 2a, la matrice de contrôle de parité H est de taille $M \times N$, soit M lignes et N colonnes, et fait correspondre les N variables du mot de code X aux M équations de parité eq1 à eqM. Ainsi, chaque équation de parité dont les coefficients sont les éléments d'une ligne de la matrice H comporte *dc* variables correspondant aux *dc* éléments à "1" de ladite ligne, et chaque variable relative à une colonne de la matrice H est impliquée dans dv équations de parité correspondant aux *dv* éléments à "1" de ladite colonne. Selon une implémentation de l'invention, la matrice de contrôle de parité H est semi-régulière, c'est-à-dire chaque équation de parité eq1 à eqM a le même nombre de variables, mais chaque variable c1 à cK et p1 à pM n'est pas connectée au même nombre d'équations. Ceci correspond à une matrice de parité comportant le même nombre de "1" par ligne et un nombre différent de "1" par colonne.

La matrice de contrôle de parité H est composée de deux matrices : une matrice systématique $H_c$ de taille $M \times K$ associée aux variables de données c1 à cK du vecteur de données C, et une matrice de parité carrée $H_p$ de taille $M \times M$ associée aux variables de parité p1 à pM du vecteur de parité P.

Le mot de code X est décomposé de la façon suivante X = [C P] et respecte l'équation :

$$HX^T = [H_C \ H_p] \begin{bmatrix} C^T \\ P^T \end{bmatrix} = 0^T \qquad (1)$$

où $X^T$, $C^T$ et $P^T$ sont les transposées des vecteurs X, C et P, l'équation (1) se décomposant en M équations de parité eq1 à eqM.

Un vecteur de projection V comprenant des variables de projection v1 à vM est défini par la relation suivante :

$$V^T = H_C \ C^T \qquad (2)$$

Les variables de parité p1 à pM du vecteur de parité P sont déduites des relations précédentes (1) et (2) dans le dispositif encodeur CD :

$$P^T = H_p^{-1} V^T \qquad (3)$$

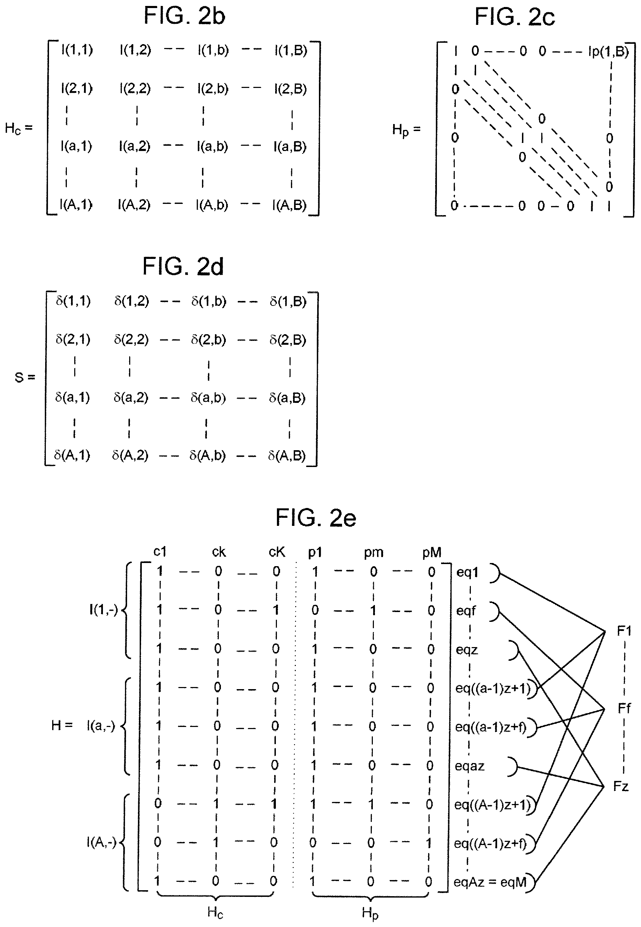

En référence à la figure 2b et la relation (2), la matrice systématique $H_c$ de forme quasi-cyclique fait correspondre les variables de données c1 à cK du vecteur de données C aux variables de projection v1 à vM du vecteur de projection V. La matrice systématique $H_c$ est constituée de AxB sous-matrices carrées I(a,b) de taille $z \times z$ avec $1 \le a \le A$ et $1 \le b \le B$. Les sous-matrices carrées sont des matrices nulles et/ou des matrices identités permutées à gauche selon un coefficient de permutation propre à chacune de ces matrices identités.

Dans le but de minimiser l'espace mémoire du dispositif encodeur CD et du dispositif décodeur DC, la matrice systématique $H_c$ est définie par une matrice simplifiée S représentée à la figure 2d. La matrice S contient les coefficients de permutation respectifs des sous-matrices carrées, chaque coefficient définissant le type de sous-matrice auquel il est associé. Ainsi chaque sous-matrice carrée I(a,b) de la matrice $H_c$ est associée à un coefficient de permutation $\delta(a,b)$ de la matrice S. Si le coefficient $\delta(a,b)$ est négatif alors la sous-matrice carrée I(a,b) est une matrice nulle. Dans le cas contraire, la sous-matrice carrée I(a,b) est une matrice identité permutée de $\delta(a,b)$ positions à gauche.

Selon l'invention, le choix des valeurs des coefficients de permutation répertoriés dans la matrice simplifiée S respecte une ou des règles de construction de la matrice de contrôle de parité H, en particulier de la matrice systématique $H_c$. Ces règles, détaillées dans la suite de la description, optimisent le décodage du mot reçu Y en terme de rapidité de convergence de l'algorithme de décodage et sont basées sur des contraintes matérielles imposées dans le dispositif décodeur.

En se référant à la figure 2c et la relation (3), la matrice de parité $H_p$, qui est constante, fait correspondre les variables de projection v1 à vM du vecteur de projection V aux variables de parité p1 à pM du vecteur de parité P. La matrice de parité $H_p$ est composée de $A \times A$ sous-matrices carrées dont les sous-matrices I et Ip (1, A) de même taille $z \times z$. Les sous-matrices carrées I sont des matrices identités disposées bi-diagonalement dans la matrice $H_p$, c'est-à-dire dans la diagonale centrale et une sous-diagonale jouxtant et parallèle à la diagonale centrale dans la matrice $H_p$. La sous-matrice carrée Ip(1, A) est une matrice identité permutée non circulairement d'une position par exemple vers la gauche, c'est-à-dire ayant la colonne de droite constituée de "0". Par exemple la sous-matrice carrée Ip(1, A) de taille 4x4 est :

$$\begin{bmatrix} 0 & 0 & 0 & 0 \\ 1 & 0 & 0 & 0 \\ 0 & 1 & 0 & 0 \\ 0 & 0 & 1 & 0 \end{bmatrix}$$

La définition d'une telle sous matrice permet un codage simple du code LDPC.

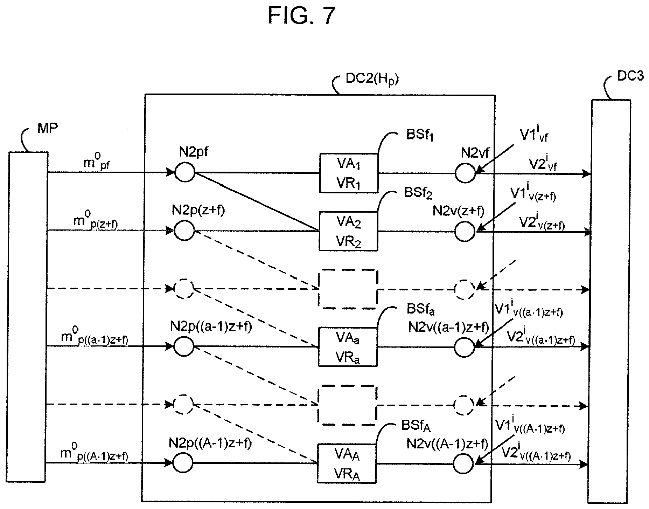

La forme de la matrice de contrôle de parité $H_p$ définit un code de la famille des codes IRA (Irregular Repeat-Accumulate). Ce code est une accumulation série de codes de parité et d'un code convolutif récursif à une bascule, représentée à la figure 7.

Ainsi la matrice de contrôle de parité H telle que représentée à la figure 2e relativement aux figures 2b et 2c représentant respectivement les matrices $H_c$ et $H_p$, comporte A lignes de sous-matrices carrées de taille z × z et A + B colonnes de sous-matrices carrées de taille z × z. Chaque ligne a de sous-matrices, avec $1 \le a \le A$, comprend z équations de parité, la matrice de contrôle de parité comportant alors un total de A z = M équations de parité.

Afin d'optimiser le décodage d'un signal de données codées reçu en entrée du dispositif décodeur DC, la matrice de contrôle de parité H est découpée en z fenêtres de décodage comportant chacune A équations de parité. Chaque fenêtre de décodage Ff d'indice f, avec $1 \le f \le z$, comprend les A équations suivantes : eqf, eq(z+f),..., eq((a-1)z+f),..., eq((A-1)z+f). Une fenêtre de décodage Ff comprend une équation de parité par ligne de sous-matrices carrées de taille z×z.

Le décodage d'un signal de données codées divisé en fenêtres de décodage Ff a pour avantage d'améliorer la convergence de l'algorithme de décodage. Des variables déterminées lors du décodage d'une fenêtre Ff à A équations de parité sont utilisées pour le décodage des A équations de parité des fenêtres de décodage suivantes F(f+1).

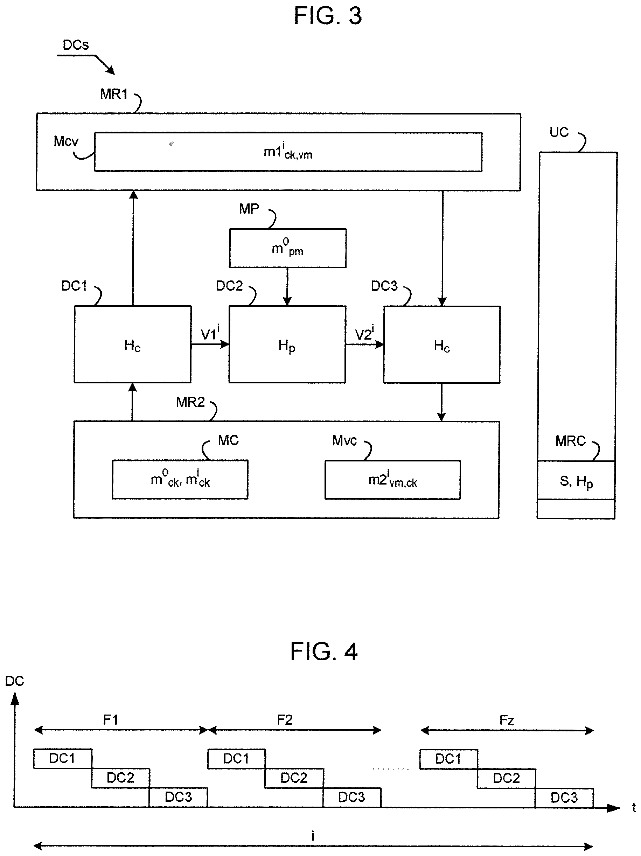

La matrice de contrôle de parité selon l'invention est construite afin d'une part d'optimiser la convergence de l'algorithme de décodage, d'autre part de considérer les exigences de coût de matériel imposées. Ces deux contraintes sont respectées par une gestion diversifiée de l'ordonnancement d'exécution du dispositif décodeur, telle que représentée aux figures 3, 8, 12 et 14, le contenu de la matrice de contrôle de parité H dépendant de l'ordonnancement choisi et de l'architecture du dispositif décodeur choisie.

La matrice H et plus particulièrement la matrice systématique $H_c$ sont construites selon une ou des règles de construction basées sur les valeurs des coefficients de permutation δ(a,b) répertoriés dans la matrice simplifiée S. A chaque type d'ordonnancement série, parallèle ou semi-parallélisé, correspond une ou des règles de construction de la matrice systématique $H_c$. Ces règles de construction évitent des conflits d'accès mémoire dans le dispositif décodeur dus notamment à l'implication d'une même variable de données dans au moins deux équations de parité traitées de manière simultanée, ce qui accroît la rapidité de convergence de l'algorithme de décodage et le débit du dispositif décodeur. Ainsi une première règle de construction consiste en ce qu'une variable de données impliquée dans le traitement d'une fenêtre de décodage Ff contenant A équations de parité ne soit impliquée que dans l'une des A équations de parité de la fenêtre et ne soit pas impliquée dans des étapes de décodage d'au moins une autre fenêtre de décodage, par exemple lorsque plusieurs fenêtres de décodage sont traitées simultanément, tant que le traitement de ladite fenêtre n'est pas terminé. Ceci est exprimé au moins par un "1" pour un seul des A éléments dans au moins une colonne de la matrice systématique $H_c$ associés à une fenêtre de décodage Ff et par des "0" pour les autres A - 1 éléments de la colonne associées à la fenêtre de décodage Ff.

En se référant de nouveau à la figure 1, le dispositif encodeur CD de l'entité émettrice EM comprend deux codeurs CD1 et CD2 correspondant chacun à un processeur ayant généré un code pour coder à partir de la matrice de contrôle de parité H. Le code du codeur CD1 détermine les variables v1 à vM du vecteur de projection V selon la relation (2) en fonction de la matrice systématique $H_c$ et des variables c1 à cK du vecteur de données C générées par la source SC. Le code du codeur CD2 détermine les variables p1 à pM du vecteur de parité P selon la relation (3) en fonction de la matrice $H_p$ et des variables v1 à vM du vecteur de projection V précédemment déterminées par le codeur CD1. Le mot de code X en sortie du dispositif encodeur CD est formé des variables c1 à cK du vecteur de données C et des variables p1 à pM du vecteur de parité P. Les variables impliquées dans le codage de la séquence de données sont des valeurs binaires "0" ou "1".

A la réception du signal de données codées déformé, les variables binaires des vecteurs C et P sont pour certaines également déformées et erronées. Pour obtenir des variables de données similaires à celles générées par l'unité source SC du dispositif encodeur CD, en sortie du dispositif décodeur DC, celui-ci estime à chaque itération i des variables de données, appelées dans la suite de la description "variables de vraisemblance", qui formeront le signal de code estimé. Après un nombre prédéfini I d'itérations, les variables de vraisemblance sont utilisées pour déterminer le vecteur $C^I$ estimé se rapprochant le plus du vecteur C généré. L'algorithme de décodage mis en œuvre dans le dispositif décodeur DC est basé sur l'algorithme de propagation de croyance BP ("Belief Propagation" en anglais) qui est un algorithme itératif à entrées souples.

Toutes les variables impliquées dans l'algorithme de décodage sont des variables pondérées par exemple du type LLR ("Log Likehood Ratio" en anglais), comportant chacune un signe définissant la valeur binaire dure "0" ou "1" de la variable et une valeur souple précisant la fiabilité de cette valeur binaire dure.

En référence à la **figure 3,** le dispositif décodeur DCs mettant en œuvre l'algorithme de décodage selon le premier ordonnancement comprend trois décodeurs DC1, DC2 et DC3, des mémoires MR1, MR2 et MP et une unité de contrôle UC qui contrôle l'ensemble des éléments du dispositif décodeur DC. Tous ces éléments sont représentés sous forme de blocs fonctionnels dont la plupart assurent des fonctions ayant un lien avec l'invention et peuvent correspondre à des modules logiciels et/ou matériels.

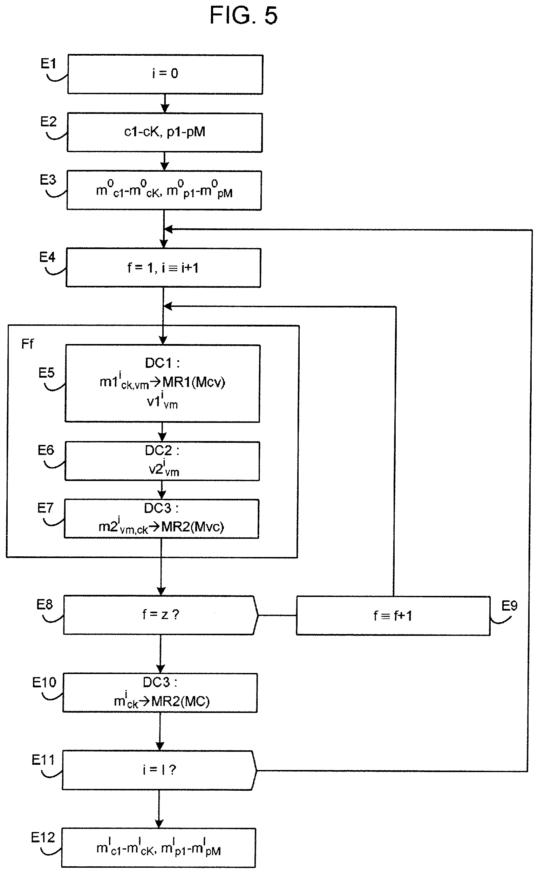

Les trois décodeurs DC1, DC2 et DC3 sont des processeurs comportant chacun une partie des instructions de décodage selon l'algorithme de décodage LDPC, établies en dépendance de la matrice de contrôle de parité H. Le fonctionnement des trois décodeurs est décrit plus en détail en référence aux figures 5, 6, 7 et 8.

La mémoire MR1 comprend au moins un espace mémoire Mcv contenant pour chaque traitement d'une fenêtre de décodage Ff des premières variables extrinsèques $m1^i_{ck,vm}$ déterminées par le décodeur DC1 et échangées entre le décodeur DC1 et le décodeur DC3, avec l'indice ck tel que $c1 \leq ck \leq cK$ et l'indice vm tel que $v1 \leq vm \leq vM$.

La mémoire MR2 comprend un espace mémoire Mvc contenant pour chaque itération i des deuxièmes variables extrinsèques $m2^i_{vm,ck}$ déterminées par le décodeur DC3 et échangées entre le décodeur DC3 et le décodeur DC1, avec les indices vm et ck tels que $v1 \leq vm \leq vM$ et $c1 \leq ck \leq cK$. La mémoire MR2 comprend également un espace mémoire de données MC contenant des variables de données intrinsèques $m^0_{c1}$ à $m^0_{cK}$ obtenues à partir de l'observation du canal de transmission CT et des variables de vraisemblance $m^i_{c1}$ à $m^i_{cK}$ estimées par le décodeur DC3 à chaque itération I et devant correspondre aux variables de données émises c1 à cK.

La mémoire de parité MP, accessible par le décodeur DC2, comprend des variables de parité intrinsèques $m^0_{p1}$ et $m^0_{pM}$ obtenues à partir de l'observation du vecteur de parité P provenant du canal CT.

Pour diminuer les coûts matériels liés à l'architecture du dispositif décodeur, les espaces-mémoires MC, Mvc et Mcv et la mémoire MP sont considérées comme des mémoires ayant un simple port dont les accès en lecture et en écriture ne sont pas simultanés.

Les variables $m1^i_{ck,vm}$, $m^0_{c1}$ à $m^0_{cK}$, $m2^1_{vm,cki}$, $m^i_{c1}$ à $m^i_{cK}$ et $m^0_{p1}$ et $m^0_{pM}$ sont des variables pondérées de type LLR ("Log Likehood Ratio" en anglais).

Les décodeurs DC1, DC2, DC3 et les mémoires du dispositif décodeur DCs sont contrôlées par l'unité de contrôle UC qui gère l'accès aux mémoires et l'ordonnancement du fonctionnement des décodeurs en fonction du contenu de la matrice de contrôle de parité H et plus particulièrement de la matrice simplifiée S, et des fenêtres de décodage F1 à Fz. L'unité UC comprend ou est reliée à une mémoire de contrôle MRC contenant notamment la matrice simplifiée S et la matrice de parité $H_p$.

Selon un premier ordonnancement de fonctionnement de type série, représenté à la figure 4, les trois décodeurs DC1, DC2 et DC3 fonctionnent chacun à leur tour pour traiter une fenêtre de décodage à la fois.

Pour optimiser la convergence du décodage, la règle de construction de la matrice de contrôle de parité H relative à l'ordonnancement série est la suivante. Toutes les variables de données impliquées dans les équations de parité d'une fenêtre de décodage doivent être différentes, ce qui conduit à ce que les coefficients de permutation positifs associés aux matrices identités dans une même colonne de la matrice systématique S soient différents.

Cette règle de construction s'exprime par la relation suivante pour la colonne d'indice b :

$$\delta(a, b) \neq \delta(j, b),$$

V $a \neq j$ tels que $1 \leq a \leq A$ et $1 \leq j \leq A$, et $\forall$ b tel que $1 \leq b \leq B$, en référence à la figure 2c.

**L'algorithme de décodage** relatif à l'ordonnancement série représenté à la figure 5 comprend des étapes E1 à E12.

A la réception du signal de transmission contenant le mot de code déformé Y, aux étapes E1 et E2, l'unité de contrôle UC du dispositif décodeur DCs détermine une variable intrinsèque de type LLR en fonction de chaque variable binaire transmise c1 à cK et p1 à pM des vecteurs déformés respectifs C et P, à l'étape E3. L'unité de contrôle UC détermine les variables de données intrinsèques $m^0_{c1}$ à $m^0_{cK}$ à partir des variables transmises du vecteur de données C déformé, et les variables de parité intrinsèques $m^0_{p1}$ à $m^0_{pM}$ à partir des variables transmises du vecteur de parité P déformé. Toutes les variables intrinsèques déterminées sont mémorisées dans l'espace mémoire MC de la mémoire MR2.

A chaque itération i aux étapes E4 à E11, le dispositif décodeur DCs traite les z fenêtres de décodage. Lors du traitement d'une fenêtre de décodage Ff comprenant A équations de parité, avec $1 \leq f \leq z$ et pour tout type d'ordonnancement, l'algorithme de décodage comprend trois étapes distinctes de décodage E5, E6 et E7 traitées respectivement dans les décodeurs DC1, DC2 et DC3 du dispositif décodeur DCs.

A chaque traitement d'une fenêtre de décodage Ff, l'unité UC autorise les décodeurs à accéder en écriture et lecture dans les mémoires MR1, MR2 et MP pour y lire et écrire des variables impliquées respectivement dans les A équations de la fenêtre Ff en dépendance des éléments de la matrice simplifiée S et de la matrice $H_p$ lues dans la mémoire MRC, au cours du décodage.

La première étape de décodage E5 mise en œuvre dans le **décodeur DC1,** activée par l'unité de contrôle UC, consiste à résoudre les A équations de parité de la fenêtre Ff définies par la matrice systématique $H_c$ à partir notamment des variables de données intrinsèques $m^0{}_{c1}$ à $m^0{}_{cK}$ pour obtenir A premières variables intermédiaires, dites premières variables de projection pondérées $V1^i{}_{vf}$, $V1^i{}_{v(z+f)}$,..., $V1^i{}_{v((a-1)z+f)}$,..., $V1^i{}_{v((A-1)z+f)}$ à fournir au décodeur DC2.

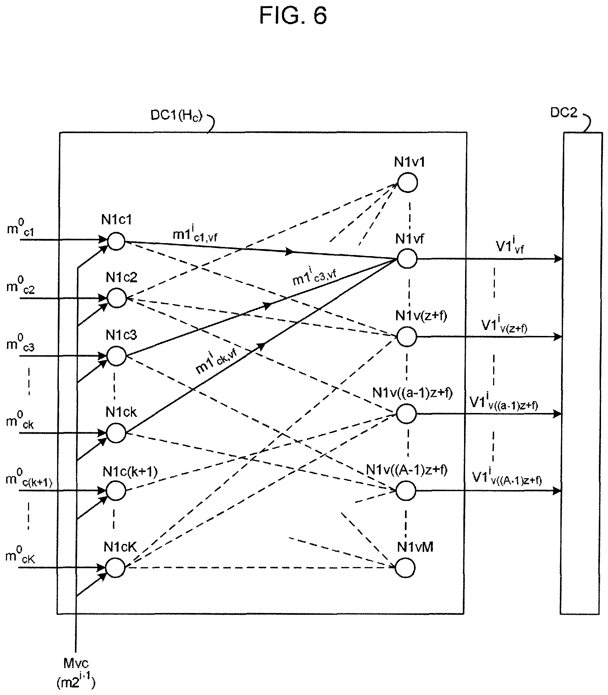

La partie des instructions de décodage LDPC dans le décodeur DC1 est schématisée à la figure 6 par des nœuds de données N1c1 à N1cK gérant les variables de données c1 à cK et connectés en conformité avec la matrice systématique $H_c$ à des nœuds de projection N1v1 à N1vM gérant des variables de projection v1 à vM. Seuls les nœuds de projection N1vf, N1v(z+f),..., N1v((a-1)z+f),... et N1v((A-1)z+f) interviennent dans le traitement des A équations de parité de la fenêtre Ff, en accord avec la figure 2e.

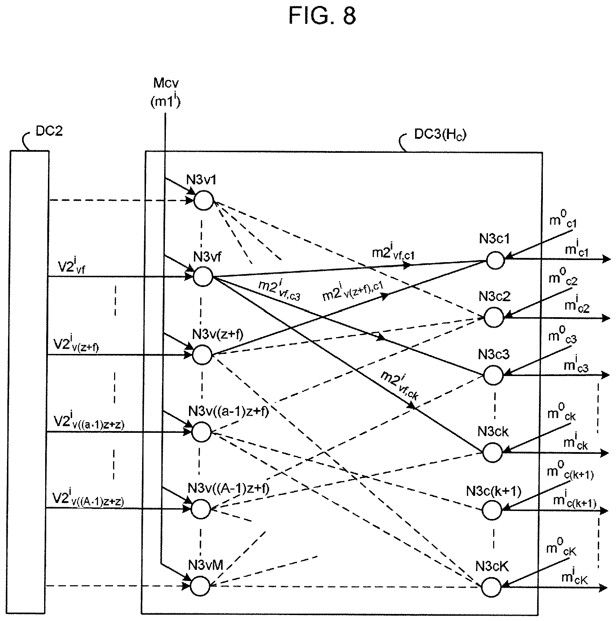

Lors du traitement de l'une des A équations de la fenêtre Ff, mettant en relation de nœuds de données à un nœud de projection, par exemple le nœud de projection N1vf, chaque nœud de données N1ck associée à une variable de données ck intervenant dans l'équation détermine une première variable extrinsèque $m1^i{}_{ckvf}$ à fournir au nœud de projection N1vf. La première variable extrinsèque $m1^i{}_{ckvf}$ associée à la variable de donnée ck est déterminée par application d'une fonction g à la variable de données intrinsèque $m^0{}_{ck}$ mémorisée dans l'espace mémoire MC et à des deuxièmes variables extrinsèques $m2^{i-1}{}_{vj,ck}$ associées aux autres variables de projection vj, avec l'indice j différent de l'indice f, relatives aux autres équations de parité eqj qui contiennent la variable de donnée ck. Ces deuxièmes variables extrinsèques $m2^{i-1}{}_{vj,ck}$ sont déterminées par le décodeur DC3 lors de l'itération précédente i-1 et sont mémorisées dans l'espace mémoire Mvc de la mémoire MR2. La détermination de ces variables extrinsèques est détaillée en référence à la figure 8.

Selon un exemple illustré à la figure 6 et en partie à la figure 8, lors de la résolution de l'une des A équations de la fenêtre Ff mettant en correspondance les nœuds de données N1c1, N1c3 et N1ck au nœud de projection N1vf, le nœud de données N1c1 détermine et transmet au nœud de projection N1vf la première variable extrinsèque $m1^i{}_{c1,vf}$ déterminée selon la relation suivante :

$$m1^i{}_{c1,vf} = g(m^0{}_{c1}, \; m2^{i-1}{}_{v(z+f),c1}),$$

Dans cette relation, la deuxième variable extrinsèque $m2^{i-1}{}_{vf,c1}$ relative à la variable de projection vf et déterminée par le décodeur DC3 lors de l'itération précédente i-1 n'est pas impliquée dans la détermination de la première variable extrinsèque $m1^i{}_{c1,vf}$, et la fonction g est la fonction de résolution d'une équation de parité. Pour des variables de type LLR et dans le cas d'un algorithme simplifié, la fonction g peut être telle que :

$$g(x_1, \dots x_q, \dots x_Q) = $$
$$\text{sign}(x_1) \dots \text{sign}(x_q) \dots \text{sign}(x_Q) \; \min(|x_1|, .. |x_q|, ... |x_Q|),$$

où "sign" est la fonction signe définissant la valeur binaire dure "0" ou "1" d'une variable $x_q$ et $|x_q|$ une valeur souple positive précisant la fiabilité de cette valeur binaire dure.

Les premières variables extrinsèques résultant de la résolution des A équations de la fenêtre Ff pour l'itération i à partir de la matrice systématique $H_c$ sont déterminées simultanément et sont fournies aux A nœuds de projection associés N1vf, N1v(z+f),..., N1v((a-1)z+f),... et N1v((A-1)z+f).

A la réception des premières variables extrinsèques, chaque nœud de projection, par exemple le nœud N1vf, intervenant dans la résolution des A équations de la fenêtre de décodage Ff détermine une première variable de projection pondérée $V1^i{}_{vf}$ à transmettre au décodeur DC2.

La première variable de projection pondérée $V1^i{}_{vf}$ est déterminée dans le nœud de projection N1vf par application de la fonction g sur toutes les premières variables extrinsèques transmises par les de nœuds de données auxquels le nœud N1vf est relié.

Selon un exemple en référence à la figure 6, le nœud de projection N1vf connecté aux nœuds de données N1c1, N1c3 et N1ck reçoit les premières variables extrinsèques $m1^i{}_{c1,vf}$, $m1^i{}_{c3,vf}$ et $m1^i{}_{ck,vf}$ respectivement depuis les trois nœuds de données précités et détermine la première variable de projection $V1^i{}_{vf}$ selon la relation suivante :

$$V1^i_{vf} = g(m1^i_{c1,vf}, m1^i_{c3,vf}, m1^i_{ck,vf}).$$

Le décodeur DC1 fournit au décodeur DC2 les premières variables de projection pondérées $V1^i_{vf}$, $V1^i_{v(z+f)}$,... $V1^i_{v((a-1)z+f)}$,... $V1^i_{v((A-1)z+f)}$ déterminées lors de la résolution des A équations de la fenêtre Ff. Puis l'unité de contrôle UC désactive le décodeur DC1.

La deuxième étape de décodage E6 mise en œuvre dans le **décodeur DC2** activé par l'unité de contrôle UC consiste à déterminer le code interne, c'est-à-dire à résoudre les A équations de parité de la fenêtre Ff définies par la matrice de parité $H_p$ à partir des A premières variables de projection pondérées $V1^i_{vf}$, $V1^i_{v(z+f)}$,..., $V1^i_{v((a-1)z+f)}$,..., $V1^i_{v((A-1)z+f)}$ produites par le décodeur DC1 et des A variables de parité intrinsèques $m^0_{pf}$, $m^0_{p(z+f)}$,..., $m^0_{p((a-1)z+f)}$,..., $m_p^0{}_{((A-1)z+f)}$ mémorisées dans la mémoire MP pour obtenir A deuxièmes variables intermédiaires, dites deuxièmes variables de projection pondérées $V2^i_{vf}$, $V2^i_{v(z+f)}$,..., $V2^i_{v((a-1)z+f)}$,..., $V2^i_{v((A-1)z+f)}$ à fournir au troisième décodeur DC3.

Le décodeur DC2 est un décodeur différentiel et utilise une technique de décodage de code convolutif à sortie pondérée selon le contenu de la matrice de parité $H_p$, comme les algorithmes d'"aller retour" FBA (Forward Backward Algorithm) tels que l'algorithme BCJR (Bahl-Cocke-Jelinek-Raviv).

La partie des instructions de décodage LDPC du décodeur DC2 de type FBA est schématisée à la figure 7 par A nœuds de projection N2vf à N2v((A-1)z+f) gérant des variables de projection et connectés respectivement à A nœuds de parité N2pf à N2p((A-1)z+f) gérant des variables de parité selon les A équations de parité de la fenêtre Ff définies par la matrice $H_p$.

Chaque équation de parité définie par la matrice Hp, par exemple l'équation eq(z+f), relie le nœud de projection N2v(z+f) au nœud de parité N2p(z+f) associé par une bascule $BSf_2$ elle-même reliée au nœud de parité N2pf relatif à l'équation précédente eqf. La première bascule $BSf_1$ n'est reliée qu'au nœud de parité N2pf associé, et le dernier nœud de parité N2p((A-1)z+f) n'est relié qu'à la bascule $BSf_A$ associée.

L'algorithme de décodage dans le décodeur DC2 de type FBA comprend trois sous-étapes connues.

A la première sous-étape, chaque bascule $BSf_a$ relative à la résolution de l'équation de parité respective eq((a-1)z+f), avec a variant de 1 à A, détermine et mémorise successivement une valeur d'aller $VA_a$ selon la relation suivante :

$$VA_a = g((m^0_{p((a-2)z+f)} + VA_{a-1}), V1^i_{v((a-1)z+f)})$$

dans laquelle la variable de parité intrinsèque $m^0_{p((a-2)z+f)}$ est relative à l'équation de parité eq((a-2)z+f), la valeur d'aller $VA_{a-1}$ est déterminée précédemment dans la bascule $BSf_{a-1}$ relative également à l'équation eq((a-2)z+f), et la première variable de projection pondérée $V1^i_{v((a-1)z+f)}$ est relative à l'équation eq((a-1)z+f).

A la deuxième sous-étape, chaque bascule successive $BSf_a$, avec a variant de A à 1, détermine et mémorise une valeur de retour $VR_a$ selon la relation suivante :

$$VR_a = g((m^0_{p(az+f)} + VR_{a+1}), V1^i_{v(az+f)})$$

dans laquelle la variable de parité intrinsèque $m^0_{p(az+f)}$ et la première variable de projection $V1^i_{v(az+f)}$ sont relatives à l'équation de parité eq(az+f) et la variable de retour $VR_{a+1}$ est déterminée précédemment dans la bascule $BSf_{a+1}$ relative à l'équation eq(az+f).

Enfin à la troisième sous-étape, chaque bascule $BSf_a$, avec a compris entre 1 et A, détermine une deuxième variable de projection pondérée $V2^i_{v((a-1)z+f)}$ selon la relation suivante :

$$V2^i_{v((a-1)z+f)} = g(m^0_{p(az+f)} + VA_{a-1}, m^0_{p((a-1)z+f)} + VR_a)$$

Toutes les deuxièmes variables de projection pondérées $V2^i_{vf}$, $V2^i_{v(z+f)}$,..., $V2^i_{v((a-1)z+f)}$,..., $V2^i_{v((A-1)z+f)}$ relatives à la fenêtre de décodage Ff et déterminées par le décodeur DC2 sont fournies au décodeur DC3. Puis l'unité de contrôle UC désactive le décodeur DC2.

Le décodage par fenêtre de décodage a pour avantage de diminuer l'espace mémoire utile dans le décodeur DC2 en ne mémorisant uniquement que les A variables d'aller $VA_1$ à $VA_A$ et les A variables de retour $VR_1$ à $VR_A$ à chaque traitement d'une fenêtre de décodage Ff. Cependant le décodage par fenêtre induit une discontinuité des variables au bord de chaque fenêtre Ff lors de la détermination de la première variable d'aller $VA_1$ qui ne dépend pas de la dernière variable $VA_A$ de la fenêtre précédente F(f-1). Pour minimiser les effets de bord et initialiser proprement le décodage de parité dans la fenêtre suivante Ff, après la fourniture des deuxièmes variables de projection pondérées au décodeur DC3, le décodeur DC2 mémorise dans la bascule $BSf_1$ la valeur $VA_A$ qui devient alors la valeur $VA_1$ lors du traitement de la fenêtre suivante Ff.

La troisième étape de décodage E7 mise en œuvre dans le décodeur DC3 activé par l'unité de contrôle UC consiste à vérifier les A équations de parité de la fenêtre Ff définies par à la matrice systématique $H_c$ en déterminant des deuxièmes variables intrinsèques à partir des deuxièmes variables de projection pondérées $V2^i_{vf}$, $V2^i_{v(z+f)}$,..., $V2^i_{v((a-1)z+f)}$,..., $V2^i_{v((A-1)z+f)}$ fournies par le décodeur DC2.

La partie des instructions de décodage LDPC dans le **décodeur DC3** est schématisée à la figure 8 par des nœuds de projection N3v1 à N3vM gérant des variables de projection v1 à vM, connectés selon la matrice systématique $H_c$ à des nœuds de données N3c1 à N3cK gérant des variables de données c1 à cK. Seuls les nœuds de projection N1vf, N1v(z+f),..., N1v((a-1)z+f),... et N1v((A-1)z+f) interviennent dans le traitement des A équations de parité de la fenêtre Ff.

Lors de la vérification de l'une des A équations de parité de la fenêtre de décodage Ff, par exemple l'équation eqf, le nœud de projection N3vf associé à la variable de projection $V2^i_{vf}$ détermine *dc* deuxièmes variables extrinsèques à fournir aux *dc* nœuds de données dont les variables de données associées sont impliquées dans l'équation de parité eqf. La deuxième variable extrinsèque $m2^i_{vf,ck}$ à fournir au nœud de donnée N3ck dont la variable de données ck associée est impliquée dans l'équation de parité eqf, est déterminée par application de la fonction g sur la deuxième variable de projection pondérée $V2^i_{vf}$ associée à la variable de projection vf et fournie par le décodeur DC2, et sur les premières variables extrinsèques $m1^i_{cj,vf}$ associées aux autres variables de données cj, avec j différent de k, impliquées dans l'équation de parité eqf et déterminées par le décodeur DC1 lors de la première étape de décodage.

Selon un exemple en référence à la figure 8, le nœud de projection N3vf détermine et transmet respectivement aux nœuds de données N3c1, N3c3 et N3ck les deuxièmes variables extrinsèques $m2^i_{vf,c1}$, $m2^i_{vf,c3}$ et $m2^i_{vf,ck}$.

Le nœud de projection N3vf détermine la deuxième variable extrinsèque $m2^i_{vf,c1}$ à fournir au nœud de données N3c1 selon la relation suivante :

$$m2^i_{vf,c1} = g(V2^i_{vf}, m1^i_{c3,vf}, m1^i_{ck,vf}),$$

où la première variable extrinsèque $m1^i_{c1,vf}$ relative à la variable de données c1 et déterminée précédemment par le décodeur DC1 n'est pas impliquée dans la détermination de la variable extrinsèque $m2^i_{vf,c1}$.

Chaque nœud de données N3ck commande la mémorisation des deuxièmes variables extrinsèques fournies dans l'espace mémoire Mvc de la mémoire MR2. Puis l'unité de contrôle UC désactive le décodeur DC3.

Les deuxièmes variables extrinsèques fournies seront impliquées dans la détermination des premières variables extrinsèques dans le décodeur DC1 lors de l'itération suivante i+1.

A l'**étape E8** l'unité de contrôle UC vérifie si toutes les z fenêtres de décodage sont traitées. Dans le cas contraire une autre fenêtre de décodage est implémentée à l'étape E9 et est traitée aux étapes E5 à E7.

Si les z fenêtres de décodage sont traitées, l'unité de contrôle UC active le décodeur DC3 à l'étape E10 pour estimer les variables de vraisemblance $m^I_{c1}$ à $m^I_{cK}$. Chaque variable de vraisemblance $m^i_{ck}$ est estimée par application de la fonction g sur la variable intrinsèque $m^0_{ck}$ associée et mémorisée dans l'espace mémoire MC et sur les deuxièmes variables extrinsèques $m2^i_{vf,ck}$ associées à la variable de données ck et mémorisées dans l'espace mémoire Mcv de la mémoire MR2.

Selon un exemple en référence à la figure 8, le nœud de données N3c1 estime la variable de vraisemblance $m^i_{c1}$ suivant la relation, en supposant que seules les deuxièmes variables extrinsèques $m2^i_{vf,c1}$ et $m2^i_{v(z+f),c1}$ sont associées à la variable de données c1 :

$$m^i_{c1} = g(m^0_{c1}, m2^i_{vf,c1}, m2^i_{v(z+f),c1}).$$

A l'**étape E11,** l'unité de contrôle UC vérifie si toutes les I itérations sont exécutées. Dans le cas contraire, une autre itération i est implémentée à l'étape E4 et les z fenêtres de décodage sont à nouveau traitées aux étapes E5 à E8.

Si les I itérations sont traitées, l'unité de contrôle UC établit un signal de données estimé contenant les variables de vraisemblance $m^I_{c1}$ à $m^I_{cK}$ correspondant sensiblement aux variables de données générées par la source SC de l'entité émettrice EM, et fournit le signal de données estimées au récepteur d'information RI de l'entité réceptrice ER, à l'étape E12.

Idéalement, la résolution d'une équation de parité devrait se faire en un coup d'horloge nécessitant le chargement en parallèle de toutes les variables impliquées dans la résolution de l'équation de parité.

Une première réalisation consiste à lire dans les mémoires MR1, MR2, et MP à une cadence supérieure à la cadence de fonctionnement des décodeurs.

Une deuxième réalisation consiste à diviser les espaces-mémoires MC, Mcv et Mvc et la mémoire MP en sous-bancs mémoires, les espaces-mémoires et la mémoire MP étant des mémoires simple port nécessitant une écriture et une lecture à la fois. La division des mémoires simple port se fait en tenant compte des propriétés de construction de la matrice de contrôle de parité H. Les *dc* variables impliquées dans une équation de parité sont définies par *dc* "1" dans la ligne de la matrice de contrôle de parité H définissant l'équation. Par construction, chaque "1" appartient à *de* blocs de taille zxz différents. Une découpe judicieuse pour les espaces-mémoires MC, Mcv et Mvc et la mémoire MP, définie en A bancs-mémoires de taille z évite tout conflit d'accès à une mémoire simple port.

Le débit de décodage D de l'ordonnancement série s'exprime par la relation suivante :

$$D = K/(3\ F\ T\ I)$$

avec K le nombre total de variables de données, z la taille d'une matrice carré, I le nombre d'itération et le temps T tel que : $T = \alpha\ A\ T_{clk}$, où $\alpha$ est un coefficient supérieur ou égal à 1 et proche de 1, A est le nombre d'équation de parité dans une fenêtre de décodage et $T_{clk}$ est la période d'horloge du dispositif décodeur.

L'ordonnancement série implémenté dans le dispositif décodeur DCs représenté à la figure 3 impose un traitement en série des z fenêtres de décodage lors d'une itération i, présentant ainsi une grande période d'inactivité des différents décodeurs DC1, DC2, DC3, deux des trois décodeurs étant inactifs pendant que le troisième est activé, comme cela apparaît à la figure 4.

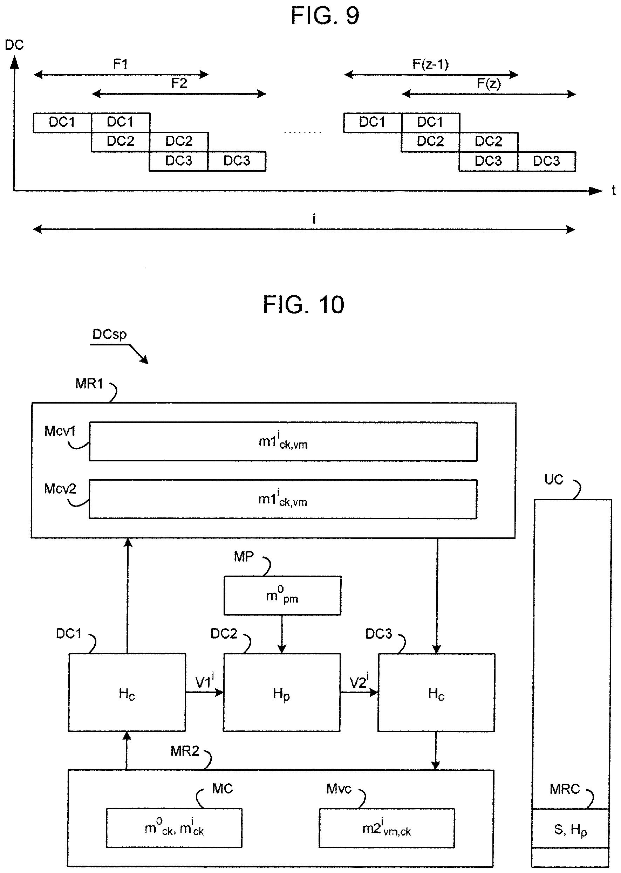

Afin de pallier la période d'inactivité des décodeurs dans le dispositif décodeur DCs, un deuxième ordonnancement dit **semi-parallèle,** représenté à la **figure 9,** met en œuvre un fonctionnement simultané de deux décodeurs sur les trois, sans activer simultanément les décodeurs DC1 et DC3 du dispositif de décodage DCsp ce qui engendrerait un problème d'accès en lecture et en écriture à l'espace mémoire Mcv dans la mémoire à simple port MR1. Les deux décodeurs DC1 et DC2, ou DC2 et DC3, fonctionnant simultanément traitent des parties différentes de deux fenêtres de décodage successives.

Dans le deuxième ordonnancement, seules deux fenêtres successives Ff et F(f+1) sont traitées semi-parallèlement à la fois, leurs traitements se chevauchant sur deux étapes de décodage. La fenêtre de décodage F(f+1) ne bénéficie pas du décodage de la fenêtre précédente Ff. La matrice de contrôle de parité H est construite de telle sorte que les variables de données impliquées dans la résolution des A équations de la fenêtre Ff et celles impliquées dans la résolution des A équations de la fenêtre F(f+1) soient différentes.

Ainsi, pour que l'algorithme de décodage converge plus rapidement tout en diminuant la latence du décodage comparativement au premier ordonnancement, les règles de construction de la matrice de contrôle de parité H relatives à l'ordonnancement semi-parallèle sont les suivantes. Selon une première règle, les coefficients de permutation positifs associés aux matrices identités dans une même colonne de la matrice simplifiée S doivent être différents entre eux. Selon une deuxième règle, dans une colonne de la matrice Hc correspondant à une variable de données, cette variable de données ne peut être traitée que pendant l'une de deux fenêtres successives ce qui est illustrée dans la matrice Hc par un seul élément "1" dans les lignes de ladite colonne relatives aux deux fenêtres successives, ou par deux coefficients de permutation quelconques dans ladite colonne de la matrice S ayant leur différence différente de 1 modulo z, où z est la taille de la matrice identité.

Ces règles de construction s'expriment par les relations suivantes pour une colonne d'indice b de la matrice S :

1)

$$\delta(a,\ b)\ \neq\ \delta(j,\ b),$$

2)

$$\delta(a,\ b)\ \neq\ (1\ +\ \delta(j,\ b))\ \bmod\ z,$$

V a ≠ j tels que 1 ≤ a ≤ A et 1 ≤ j ≤ A, et V b tel que 1 ≤ b ≤ B, en référence à la figure 2c.

Ces règles de construction ont pour avantage d'optimiser la convergence de l'algorithme de décodage de manière identique à l'ordonnancement série tout en parallélisant le fonctionnement de deux décodeurs à la fois.

L'architecture du dispositif décodeur DCsp mettant en œuvre l'ordonnancement semi-parallèle et représentée à la figure 10 ne diffère de celle mettant en œuvre l'ordonnancement série que par l'organisation de l'espace dans la mémoire MR1 permettant l'échange des premières variables extrinsèques entre le décodeur DC1 et le décodeur DC3.

La mémoire MR1 comprend deux espaces mémoires Mcv1 et Mcv2. L'espace mémoire Mcv1 est dédié à la mémorisation des premières variables extrinsèques déterminées par le décodeur DC1 lors du traitement d'une première fenêtre de décodage Ff. L'espace mémoire Mcv2 est dédié à la mémorisation des premières variables extrinsèques déterminées par le décodeur DC1 lors du traitement de la fenêtre de décodage suivante F(f+1) succédant à la première fenêtre Ff.

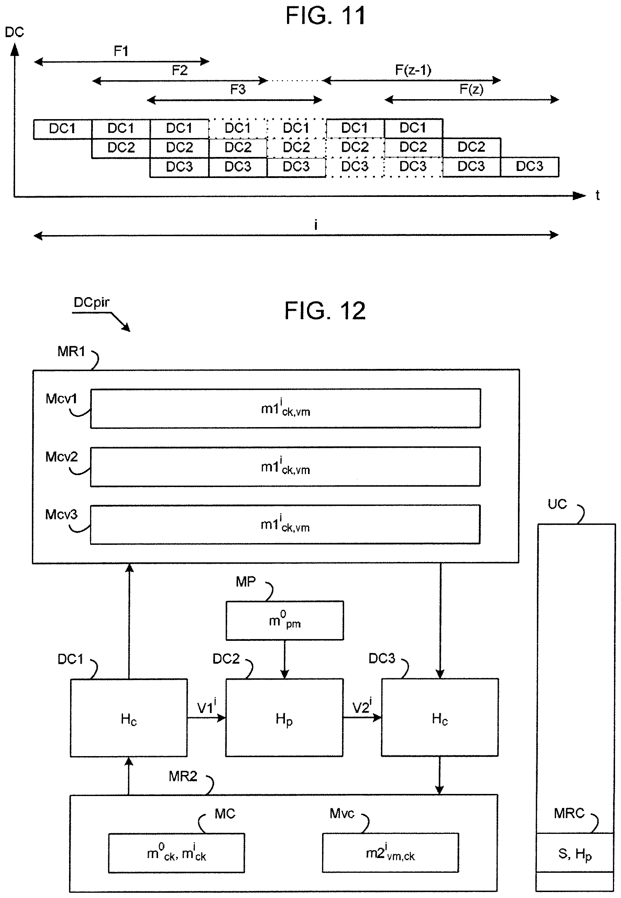

Selon le troisième ordonnancement, dit **parallèle inter-décodeur,** représenté à la **figure 11,** les trois décodeurs DC1, DC2 et DC3 fonctionnent simultanément dans le dispositif décodeur DCpir et traitent chacun une partie de trois fenêtres de décodage successives Ff, F(f+1) et F(f+2). Ainsi en parallèle, le décodeur DC1 résout les équations de parité de la fenêtre de décodage F(f+2) définie par la matrice systématique $H_c$, le décodeur DC2 traite les équations de parité de la fenêtre de décodage F(f+1) définies par la matrice de parité $H_p$ et le décodeur DC3 vérifie les équations de parité de la fenêtre Ff définies par à la matrice systématique $H_c$.

Au cours du décodage parallèle inter-décodeur des équations de parité de la fenêtre F(f+2) par le décodeur DC1 et des équations de parité de la fenêtre Ff par le décodeur DC3, une même première variable extrinsèque pourrait être impliquée dans les deux fenêtres, entraînant alors un conflit d'accès à la mémoire MR1. Pour pallier ce problème, la matrice de contrôle de parité H est construite de sorte que les variables de données impliquées dans la résolution des A équations de la fenêtre Ff, celles impliquées dans la résolution des A équations de la fenêtre F(f+1) et celles impliquées dans la résolution des A équations de la fenêtre F(f+2) soient différentes.

Ainsi, pour que l'algorithme de décodage converge plus rapidement tout en diminuant la latence du décodage et en évitant les problèmes d'accès simultanés à la mémoire MR1, les règles de construction de la matrice de contrôle de parité H relatives à l'ordonnancement parallèle inter-décodeur comprennent les première et deuxième règles définies pour le deuxième ordonnancement dit semi-parallèle et une troisième règle similaire à la deuxième règle.

Dans une colonne d'indice b de la matrice Hc correspondant à une variable de données,

1) les coefficients de permutation positifs associés aux matrices identités dans une même colonne de la matrice simplifiée S sont différents entre eux, soit :

$$\delta(a, b) \neq \delta(j, b);$$

2) la variable de données ne peut être traitée que pendant l'une de deux fenêtres successives ce qui est illustrée dans la matrice Hc par un seul élément "1" dans les lignes de ladite colonne relatives aux deux fenêtres successives, ou par deux coefficients de permutation quelconques dans ladite colonne de la matrice S ayant leur différence différente de 1 modulo z, où z est la taille de la matrice identité, soit :

$$\delta(a, b) \neq (1 + \delta(j, b)) \bmod z;$$

et

3) la variable de données ne peut être traitée que pendant l'une de trois fenêtres successives ce qui est illustrée dans la matrice Hc par un seul élément "1" dans les lignes de ladite colonne relatives aux trois fenêtres successives, ou par deux coefficients de permutation quelconques dans ladite colonne de la matrice S ayant leur différence différente de 2 modulo z, où z est la taille de la matrice identité, soit :

$$\delta(a, b) \neq (2 + \delta(j, b)) \bmod z;$$

V a ≠ j tels que 1 ≤ a ≤ A et 1 ≤ j ≤ A, et ∀ b tel que 1 ≤ b ≤ B, en référence à la figure 2c.

Le troisième ordonnancement maximise l'activité de chaque décodeur et augmente le débit de décodage d'une séquence de données du facteur suivant Fa :

$$Fa = 3\ K/(K + 2\ A)$$

avec K le nombre total de variables de données et A le nombre d'équations de parité dans une fenêtre de décodage.

L'architecture du dispositif décodeur DCpir mettant en œuvre l'ordonnancement parallèle inter-décodeurs et représentée à la figure 12 ne diffère de celles mettant en œuvre les ordonnancements série et semi-parallèle que par l'organisation de l'espace dans la mémoire MR1 permettant l'échange des premières variables extrinsèques relatives au décodage d'une fenêtre de décodage entre le décodeur DC1 et le décodeur DC3. La mémoire MR1 comprend trois espaces mémoires Mcv1, Mcv2 et Mcv3. L'espace mémoire Mcv1 est dédié à la mémorisation des premières variables extrinsèques déterminées par le décodeur DC1 lors du traitement d'une première fenêtre de décodage Ff. L'espace mémoire Mcv2 est dédié à la mémorisation des premières variables extrinsèques déterminées par le décodeur DC1 lors du traitement d'une deuxième fenêtre de décodage F(f+1) succédant à la première fenêtre. L'espace mémoire Mcv3 est dédié à la mémorisation des premières variables extrinsèques déterminées par le décodeur DC1 lors du traitement d'une troisième fenêtre de décodage F(f+2) succédant à la deuxième fenêtre. Lorsque la première fenêtre de décodage Ff a entièrement été traitée par les trois décodeurs, les premières variables extrinsèques relatives au traitement de la première fenêtre sont effacées de l'espace mémoire Mcv1. Ainsi lors du décodage d'une quatrième fenêtre de décodage F(f+3), les premières variables extrinsèques déterminées par le décodeur DC1 sont mémorisées dans l'espace mémoire Mcv1 et ainsi de suite.

La lecture par le décodeur DC1 des variables de données intrinsèques $m^0_{c1}$ à $m^0_{cK}$ mémorisées dans l'espace mémoire MC et intervenant dans le décodage de la fenêtre F(f+2) et l'écriture des variables de vraisemblance $m^i_{c1}$ à $m^i_{cK}$ relatives à la fin de chaque itération i par le décodeur DC3 dans l'espace mémoire MC, pourrait conduire à un conflit d'accès à l'espace mémoire MC. Pour remédier à ce problème, une première réalisation consiste à utiliser une mémoire à double port permettant la lecture et l'écriture de variables simultanément, sous condition que les adresses de ces variables dans l'espace mémoire MC soient différentes. Cette condition est respectée lorsque les règles de construction de la matrice H sont satisfaites.

Une autre réalisation consiste à utiliser une mémoire simple port et à diviser l'espace mémoire MC en deux bancs de mémoire, un premier banc de mémoire mémorisant les variables de données intrinsèques $m^0_{c1}$ à $m^0_{cK}$, et le deuxième banc de mémoire mémorisant les variables de vraisemblance $m^i_{c1}$ à $m^i_{cK}$.

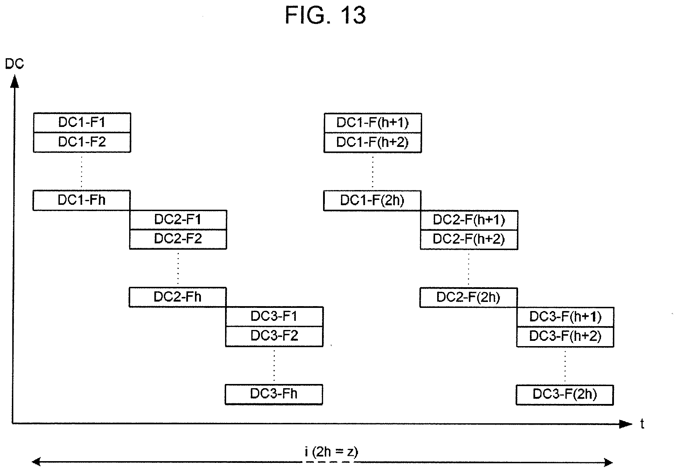

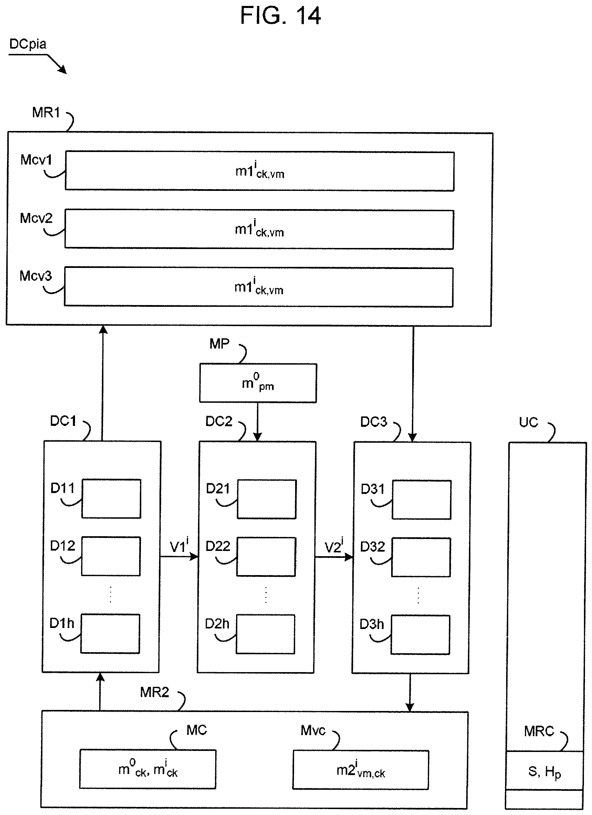

Selon le quatrième ordonnancement, dit **parallèle intra-décodeur,** représenté à la **figure 13,** chaque décodeur traite simultanément h fenêtres de décodage, le facteur h étant un sous-multiple entier du nombre de fenêtres de décodage z découpant la matrice H, l'activation de chaque décodeur DC1, DC2 et DC3 dans le dispositif décodeur DCpia se faisant en série. Le quatrième ordonnancement est représenté à la figure 14 selon un exemple pour lequel 2 h = A z.

L'architecture du dispositif de décodage DCpia mettant en ouvre le quatrième ordonnancement comprend pour chaque décodeur DC1, DC2, DC3 du dispositif de décodage DCpia, h sous-décodeurs D11 à D1h, D21 à D2h, D31 à D3h, pour traiter simultanément les h fenêtres de décodage, comme représenté à la figure 14.

L'ordonnancement parallèle intra-décodeur pourrait introduire une baisse de l'optimisation de la convergence de l'algorithme de décodage. Pour assurer une convergence rapide, une variable de données ne doit pas être impliquée plus d'une fois dans le groupe de hxA équations de parité. La règle de construction de la matrice de contrôle de parité est alors la suivante. Deux coefficients de permutation positifs associés aux matrices identités dans une même colonne d'indice b de la matrice simplifiée S doivent avoir leur différence différente de β z/h modulo z, où z est la taille de la matrice identité et β est un entier compris entre 1 et h.

Cette règle de construction s'exprime par la relation suivante :

$$\delta(a, \; b) \;\neq\; (\delta(j, \; b)+\; \beta \;\; z/h) \; \bmod \; z,$$

V a ≠ j tels que 1 ≤ a ≤ A et 1 ≤ j ≤ A, ∀ b tel que 1 ≤ b ≤ B, et V β ∈ [1, 2,... h], en référence à la figure 2c.

A partir des différentes règles de construction énoncées, tout type d'ordonnancement associé à une architecture de décodeur peut être mis en œuvre. Par exemple, une matrice de contrôle de parité peut définir un ordonnancement parallèle inter-décodeur combiné à un ordonnancement parallèle intra-décodeur en respectant les règles de construction associées aux deux ordonnancements afin d'optimiser la convergence de l'algorithme de décodage et d'éviter des conflits d'accès mémoire.

L'invention décrite ici concerne une détermination d'un code au moyen d'une construction de matrice de contrôle de parité, un codage et un dispositif encodeur pour coder un signal de données, un décodage et un dispositif décodeur pour décoder un signal de données codées. Selon une implémentation, les étapes du procédé de l'invention sont déterminées par les instructions de programmes d'ordinateur incorporés dans les dispositifs encodeur et décodeur. Les programmes comportent des instructions de programme qui, lorsque lesdits programmes sont exécutés respectivement dans le dispositif encodeur et le dispositif décodeur dont le fonctionnement est alors commandé par l'exécution des programmes, réalisent les étapes du codage et décodage selon l'invention.

En conséquence, l'invention s'applique également à des programmes d'ordinateur, notamment des programmes d'ordinateur enregistrés sur ou dans un support d'informations lisible par un ordinateur et tout dispositif de codage et de décodage de données, adapté à mettre en œuvre l'invention. Ces programmes peuvent utiliser n'importe quel langage de programmation, et être sous la forme de code source, code objet, ou de code intermédiaire entre code source et code objet tel que dans une forme partiellement compilée, ou dans n'importe quelle autre forme souhaitable pour implémenter le procédé selon l'invention.

Le support d'informations peut être n'importe quelle entité ou dispositif capable de stocker les programmes. Par exemple, le support peut comporter un moyen de stockage ou support d'enregistrement sur lequel sont enregistrés les programmes d'ordinateur selon l'invention, tel qu'une ROM, par exemple un CD ROM ou une ROM de circuit microélectronique, ou encore une clé USB, ou un moyen d'enregistrement magnétique, par exemple une disquette (floppy disc) ou un disque dur.

D'autre part, le support d'informations peut être un support transmissible tel qu'un signal électrique ou optique, qui peut être acheminé via un câble électrique ou optique, par radio ou par d'autres moyens. Les programmes selon l'invention peuvent être en particulier téléchargés sur un réseau de type internet.

Alternativement, le support d'informations peut être un circuit intégré dans lequel les programmes sont incorporés, le circuit étant adapté pour exécuter ou pour être utilisé dans l'exécution du procédé selon l'invention.

## Revendications

1. Procédé de décodage d'un signal de données codées incluant des variables de données (ck) et des variables de parité (pm), fondé sur une matrice de contrôle de parité (H) composée d'une matrice systématique ($H_c$) et d'une matrice de parité ($H_p$), dont les lignes correspondent respectivement à des coefficients d'équations de parité (eql-eqM) et sont réparties en des fenêtres de décodage (Fl, ... ,Ff, ... ,Fz) de même taille, d'indice f, avec $1 \leq f \leq z$, qui comprennent les A équations eqf, eq(z+f), ... , eq((a-1)z+f), ... , eq((A-1)z+f), dans lequel ladite matrice systématique ($H_c$) est constituée de matrices identités permutées de même taille respectivement (I(a,b)) associées à des coefficients de permutation ($\delta(a,b)$), les coefficients de permutation associés aux matrices identités dans une même colonne de la matrice systématique étant différents, et deux coefficients de permutation quelconques dans ladite colonne ont une différence différente de 1 modulo la taille des matrices identités **caractérisé en ce qu'**il comprend une résolution simultanée (E5, E6, E7) des équations de parité (eqf à eq (A-1)z+f) d'au moins une fenêtre de décodage (Ff), une variable de données n'étant impliquée que dans l'une des équations de parité de la fenêtre de décodage et n'étant pas impliquée dans la résolution d'équation de parité d'autres fenêtres de décodage tant que la résolution des équations de parité de la fenêtre de décodage n'est pas terminée.

2. Procédé de décodage conforme à la revendication 1, selon lequel les variables de données (ck) qui sont impliquées dans les équations de parité de la fenêtre de décodage ne sont impliquées chacune que dans l'une des équations de parité de la fenêtre de décodage, et ne sont pas impliquées dans la résolution d'équations de parité d'autres fenêtres de décodage tant que la résolution des équations de parité de la fenêtre de décodage n'est pas terminée.

3. Procédé de décodage conforme à la revendication 1 ou 2, **caractérisé en ce qu'**il est itératif et comprend un traitement de toutes les fenêtres de décodage (Fl à Fz) pour chaque itération (i), et
le traitement d'une fenêtre de décodage (Ff) comprend les trois étapes suivantes :

   une résolution (E5) des équations de la fenêtre de décodage associées à la matrice systématique ($H_c$) pour déterminer des premières variables extrinsèques ($ml^i\ c_k$, vm) en fonction des variables de données (ck) et de deuxièmes variables extrinsèques ($m2^{i-1}_{vm,ck}$) déterminées lors de l'itération précédente (i-1), et une détermination de premières variables intermédiaires ($Vl^i vm$) en dépendance de la matrice systématique et des premières variables extrinsèques déterminées;
   une résolution (E6) des équations de parité de la fenêtre de décodage associées à la matrice de parité ($H_p$) en fonction des premières variables intermédiaires et des variables de parité (pm) pour obtenir des deuxièmes variables intermédiaires ($V2^1 vm$), et
   une résolution (E7) des équations de parité de la fenêtre de décodage associées à la matrice systématique pour déterminer des deuxièmes variables extrinsèques ($m2^i_{vmck}$) en fonction des deuxièmes variables intermédiaires et des premières variables extrinsèques, et
   à chaque itération de décodage (i), estimer (ElO) d'autres variables de données ($m^i_{ck}$) en fonction des variables de données du signal de données codées et des deuxièmes variables extrinsèques déterminées lors du traitement de toutes les fenêtres de décodage.

4. Procédé de décodage conforme à la revendication 1, selon laquelle dans ladite matrice systématique (Hc), deux coefficients de permutation quelconques dans ladite colonne ont une différence différente de 2 modulo la taille des matrices identités.

5. Dispositif décodeur pour décoder un signal de données codées incluant des variables de données (ck) et des variables de parité (pm), fondé sur une matrice de contrôle de parité (H) composée d'une matrice systématique ($H_c$) et d'une matrice de parité (Hp) et dont les lignes correspondent respectivement à des coefficients d'équations de parité (eql-eqM) et sont réparties en des fenêtres de décodage (Fl, ..., Ff, ...,Fz) de même taille, d'indice f, avec $1 \leq f \leq z$, qui comprennent les A équations eqf, eq(z+f), ... , eq((a-1)z+f), ... , eq((A-1)z+f), dans lequel ladite matrice systématique ($H_c$) est constituée de matrices identités permutées de même taille respectivement (I(a,b)) associées à des coefficients de permutation ($\delta$(a,b)), les coefficients de permutation associés aux matrices identités dans une même colonne de la matrice systématique étant différents, **caractérisé en ce qu'**il comprend des moyens (DCI, DC2 , DC3) pour résoudre simultanément des équations de parité (eqf à eq (A-1)z+f) d'au moins une fenêtre de décodage (Ff), une variable de données n'étant impliquée que dans l'une des équations de parité de la fenêtre de décodage et n'étant pas impliquée dans la résolution d'équation de parité d'autres fenêtres de décodage tant que la résolution des équations de parité de la fenêtre de décodage n'est pas terminée.

6. Dispositif décodeur conforme à la revendication 5, **caractérisé en ce que**, pour traiter itérativement toutes les fenêtres de décodage (Fl à Fz), les moyens pour résoudre comprennent pour exécuter chaque itération de décodage (i):

 un moyen (DCI) pour résoudre des équations de la fenêtre de décodage associées à la matrice systématique ($H_c$) afin de déterminer des premières variables extrinsèques ($ml^i_{Ck,vm}$) en fonction des variables de données (ck) et de deuxièmes variables extrinsèques ($m2^{i-1}_{vm,ck}$) déterminées lors de l'itération précédente (i-1),
 un moyen (DCI) pour déterminer des premières variables intermédiaires ($VI^i_{vm}$) en dépendance de la matrice systématique et des premières variables extrinsèques déterminées;
 un moyen (DC2) pour résoudre les équations de parité de la fenêtre de décodage associées à la matrice de parité (Hp) en fonction des premières variables intermédiaires et des variables de parité (pm) afin d'obtenir des deuxièmes variables intermédiaires (V2$^i$vm), et
 un moyen (DC3) pour résoudre les équations de parité de la fenêtre de décodage associées à la matrice systématique pour déterminer des deuxièmes variables extrinsèques ($m2^i_{vmck}$) en fonction des deuxièmes variables intermédiaires et des premières variables extrinsèques, et
 à chaque itération de décodage (i), un moyen (DC3) pour estimer d'autres variables de données ($m^i_{ck}$) en fonction des variables de données du signal de données codées et des deuxièmes variables extrinsèques déterminées lors du traitement de toutes les fenêtres de décodage.

7. Programme d'ordinateur téléchargeable depuis un réseau de communication et/ou stocké sur un support lisible par ordinateur et/ou exécutable par un processeur, **caractérisé en ce qu'**il comprend des instructions pour la mise en œuvre du procédé de décodage conforme à la revendication 1.


**Patentansprüche**

1. Verfahren zum Decodieren eines Signals mit codierten Daten, die Datenvariablen (ck) und Paritätsvariablen (pm) einschließen, das auf einer Paritätsprüfmatrix (H) gründet, die sich aus einer systematischen Matrix ($H_c$) und einer Paritätsmatrix ($H_p$) zusammensetzt, deren Zeilen jeweils Koeffizienten von Paritätsgleichungen (eql-eqM) entsprechen und in Decodierfenstern (Fl, ..., Ff, ... , Fz) gleicher Größe mit Index f, wobei $1 \leq f \leq z$, verteilt sind, welche die A Gleichungen eqf, eq(z+f), ..., eq((a-1)z+f), ..., eq((A-l)z+f) umfassen, wobei die systematische Matrix ($H_c$) aus permutierten Identitätsmatrizen jeweils gleicher Größe (I(a,b)) besteht, die mit Permutationskoeffizienten ($\delta$(a,b)) assoziiert sind, wobei sich die mit den Identitätsmatrizen assoziierten Permutationskoeffizienten in einer gleichen Spalte der systematischen Matrix unterscheiden, und zwei beliebige Permutationskoeffizienten in der Spalte eine Differenz aufweisen, die sich von 1 Modulo Größe der Identitätsmatrizen unterscheidet, **dadurch gekennzeichnet, dass** es ein gleichzeitiges Auflösen (E5, E6, E7) der Paritätsgleichungen (eqf bis eq (A-1)z+f) mindestens eines Decodierfensters (Ff) umfasst, wobei eine Datenvariable nur an einer der Paritätsgleichungen des Decodierfensters beteiligt ist und nicht an der Auflösung einer Paritätsgleichung anderer Decodierfenster beteiligt ist, solange die Auflösung der Paritätsgleichungen des Decodierfensters nicht abgeschlossen ist.

2. Decodierverfahren nach Anspruch 1, wobei die Datenvariablen (ck), die an den Paritätsgleichungen des Decodierfensters beteiligt sind, jede nur an einer der Paritätsgleichungen des Decodierfensters beteiligt sind, und nicht an der Auflösung von Paritätsgleichungen anderer Decodierfenster beteiligt sind, solange die Auflösung der Paritätsgleichungen des Decodierfensters nicht abgeschlossen ist.

3. Decodierverfahren nach Anspruch 1 oder 2, **dadurch gekennzeichnet, dass** es iterativ ist und eine Verarbeitung aller der Decodierfenster (Fl bis Fz) für jede Iteration (i) umfasst, und
die Verarbeitung eines Decodierfensters (Ff) die drei folgenden Schritte umfasst:

ein Auflösen (E5) der Gleichungen des Decodierfensters, die mit der systematischen Matrix ($H_c$) assoziiert sind, um erste extrinsische Variablen ($ml^i{}_{c_k}$, vm) in Abhängigkeit von den Datenvariablen ($c_k$) und von zweiten extrinsischen Variablen ($m2^{i-1}{}_{vm,ck}$) zu bestimmen, die bei der vorhergehenden Iteration (i-1) bestimmt wurden, und ein Bestimmen von ersten Zwischenvariablen ($Vl^i$vm) in Abhängigkeit von der systemischen Matrix und den bestimmten ersten extrinsischen Variablen;
ein Auflösen (E6) der Paritätgleichungen des Decodierfensters, die mit der Paritätsmatrix ($H_p$) assoziiert sind, in Abhängigkeit von den ersten Zwischenvariablen und den Paritätsvariablen (pm), um zweite Zwischenvariablen ($V2^1$vm) zu erhalten, und
ein Auflösen (E7) der Paritätsgleichungen des Decodierfensters, die mit der systematischen Matrix assoziiert sind, um zweite extrinsische Variablen ($m2^i{}_{vnck}$) in Abhängigkeit von den zweiten Zwischenvariablen und den ersten extrinsischen Variablen zu bestimmen, und
bei jeder Decodier-Iteration (i), Schätzen (E10) von anderen Datenvariablen ($m^i{}_{ck}$) in Abhängigkeit von den Datenvariablen des Signals mit codierten Daten und den zweiten extrinsischen Variablen, die bei der Verarbeitung aller der Decodierfenster bestimmt wurden.

4. Decodierverfahren nach Anspruch 1, wobei in der systematischen Matrix ($H_c$) zwei beliebige Permutationskoeffizienten in der Spalte eine Differenz aufweisen, die sich von 2 Modulo Größe der Identitätsmatrizen unterscheidet.

5. Decodiervorrichtung zum Decodieren eines Signals mit codierten Daten, die Datenvariablen ($c_k$) und Paritätsvariablen (pm) einschließen, das auf einer Paritätsprüfmatrix (H) gründet, welche sich aus einer systematischen Matrix ($H_c$) und einer Paritätsmatrix (Hp) zusammensetzt und deren Zeilen jeweils Koeffizienten von Paritätsgleichungen (eql-eqM) entsprechen und in Decodierfenstern (Fl, ..., Ff, ..., Fz) gleicher Größe mit Index f, wobei $1 \le f \le z$, verteilt sind, die die A Gleichungen eqf, eq(z+f), ..., eq((a-1)z+f), ..., eq((A-1)z+f) umfassen, wobei die systematische Matrix ($H_c$) aus permutierten Identitätsmatrizen jeweils gleicher Größe (l(a,b)) besteht, die mit Permutationskoeffizienten ($\delta$(a,b)) assoziiert sind, wobei sich die mit den Identitätsmatrizen assoziierten Permutationskoeffizienten in einer gleichen Spalte der systematischen Matrix unterscheiden, **dadurch gekennzeichnet, dass** sie Mittel (DC1, DC2, DC3) umfasst, um Paritätsgleichungen (eqf bis eq (A-1)z+f) mindestens eines Decodierfensters (Ff) gleichzeitig aufzulösen, wobei eine Datenvariable nur an einer der Paritätsgleichungen des Decodierfensters beteiligt ist und nicht an der Auflösung einer Paritätsgleichung anderer Decodierfenster beteiligt ist, solange die Auflösung der Paritätsgleichungen des Decodierfensters nicht abgeschlossen ist.

6. Decodiervorrichtung nach Anspruch 5, **dadurch gekennzeichnet, dass**, um alle die Decodierfenster (Fl bis Fz) iterativ zu verarbeiten, die Mittel zum Auflösen, um jede Decodier-Iteration (i) auszuführen, umfassen:

ein Mittel (DC1), um Gleichungen des Decodierfensters, die mit der systematischen Matrix ($H_c$) assoziiert sind, aufzulösen, um erste extrinsische Variablen ($m1^i{}_{ck,vm}$) in Abhängigkeit von den Datenvariablen ($c_k$) und von zweiten extrinsischen Variablen ($m2^{i-1}{}_{vm,ck}$) zu bestimmen, die bei der vorhergehenden Iteration (i-1) bestimmt wurden,
ein Mittel (DC1), um erste Zwischenvariablen ($V1^i{}_{vm}$) in Abhängigkeit von der systemischen Matrix und den bestimmten ersten extrinsischen Variablen zu bestimmen;
ein Mittel (DC2), um die Paritätsgleichungen des Decodierfensters, die mit der Paritätsmatrix (Hp) assoziiert sind, in Abhängigkeit von den ersten Zwischenvariablen und den Paritätsvariablen (pm) aufzulösen, um zweite Zwischenvariablen ($V2^i$vm) zu erhalten, und
ein Mittel (DC3), um die Paritätsgleichungen des Decodierfensters, die mit der systematischen Matrix assoziiert sind, aufzulösen, um zweite extrinsische Variablen ($m2^i{}_{vmck}$) in Abhängigkeit von den zweiten Zwischenvariablen und den ersten extrinsischen Variablen zu bestimmen, und
bei jeder Decodier-Iteration (i), ein Mittel (DC3), um andere Datenvariablen ($m^i{}_{ck}$) in Abhängigkeit von den Datenvariablen des Signals mit codierten Daten und den zweiten extrinsischen Variablen, die bei der Verarbeitung aller der Decodierfenster bestimmt wurden, zu schätzen.

7. Computerprogramm, das aus einem Kommunikationsnetz heruntergeladen werden kann und/oder auf einem computerlesbaren Träger gespeichert ist und/oder von einem Prozessor ausgeführt werden kann, **dadurch gekennzeichnet, dass** es Anweisungen für die Umsetzung des Decodierverfahrens nach Anspruch 1 umfasst.

**Claims**

1. A method for decoding a coded-data signal including data variables (ck) and parity variables (pm), based on a parity check matrix (H) consisting of a systematic matrix ($H_c$) and of a parity matrix ($H_p$), the rows of which respectively correspond to parity equation coefficients (eql-eqM) and are distributed into decoding windows (F1, ..., Ff, ..., Fz) of the same size, of index f, with $1 \le f \le z$, which comprise the A equations eqf, eq(z+f), ..., eq((a-1)z+f), ..., eq(A-1)z+f), wherein said systematic matrix ($H_c$) consists of permuted identity matrices of the same size respectively (I(a,b)) associated with permutation coefficients ($\delta$(a,b)), the permutation coefficients associated with the identity matrices in a same column of the systematic matrix being different, and any two permutation coefficients in said column have a difference different from 1 modulo the size of the identity matrices, **characterised in that** it comprises simultaneously resolving (E5, E6, E7) the parity equations (eqf to eq(A-1)z+f) of at least one decoding window (Ff), a data variable being involved in only one of the parity equations of the decoding window and being not involved in resolving parity equation of other decoding windows as long as resolving parity equations of the decoding window has not ended.

2. The decoding method according to claim 1, wherein the data variables (ck) which are involved in the parity equations of the decoding window are each involved in only one of the parity equations of the decoding window, and are not involved in resolving parity equations of other decoding windows as long as resolving parity equations of the decoding window has not ended.

3. The decoding method according to claim 1 or 2, **characterised in that** it is iterative and comprises processing all the decoding windows (F1 to Fz) for each iteration (i), and
processing a decoding window (Ff) comprises the three following steps of:

resolving (E5) equations of the decoding window associated with the systematic matrix ($H_c$) to determine first extrinsic variables ($m1^i{}_{c_k}$, vm) as a function of the data variables (ck) and second extrinsic variables ($m2^{i-1}{}_{vm,ck}$) determined during the previous iteration (i-1), and determining first intervening variables ($V1^i$vm) in dependence on the systematic matrix and the first determined extrinsic variables;
resolving (E6) parity equations of the decoding window associated with the parity matrix ($H_p$) as a function of the first intervening variables and the parity variables (pm) to obtain second intervening variables ($V2^i$vm), and resolving (E7) the parity equations of the decoding window associated with the systematic matrix to determine second extrinsic variables ($m2^i{}_{vmck}$) as a function of the second intervening variables and the first extrinsic variables, and
at each decoding iteration (i), assessing (E10) other data variables ($m^i{}_{ck}$) as a function of the data variables of the coded data signal and of the second extrinsic variables determined upon processing all the decoding windows.

4. The decoding method according to claim 1, wherein in said systematic matrix ($H_c$), any two permutation coefficients in said column have a difference different from 2 modulo the size of the identity matrices.

5. A decoder device for decoding a coded data signal including data variables (ck) and parity variables (pm), based on a parity check matrix (H) consisting of a systematic matrix ($H_c$) and of a parity matrix ($H_p$) and the rows of which respectively correspond to parity equation coefficients (eql-eqM) and are distributed into decoding windows (F1, ..., Ff, ..., Fz) of the same size, of index f, with $1 \le f \le z$, which comprise the A equations eqf, eq(z+f), ..., eq((a-1)z+f), ..., eq(A-1)z+f), wherein said systematic matrix ($H_c$) consists of permuted identity matrices of the same size respectively (I(a,b)) associated with permutation coefficients ($\delta$(a,b)), the permutation coefficients associated with the identity matrices in a same column of the systematic matrix being different, **characterised in that** it comprises means (DC1, DC2, DC3) for simultaneously resolving parity equations (eqf to eq(A-1)z+f) of at least one decoding window (Ff), a data variable being involved in only one of the parity equations of the decoding window and being not involved in resolving a parity equation of other decoding windows as long as resolving parity equations of the decoding window has not ended.

6. The decoder device according to claim 5, **characterised in that**, for iteratively processing all the decoding windows (F1 to Fz), the resolving means comprise to perform each decoding iteration (i):

a means (DC1) for resolving equations of the decoding window associated with the systematic matrix ($H_c$) in order to determine first extrinsic variables ($m1^i{}_{ck,vm}$) as a function of the data variables (ck) and second extrinsic variables ($m2^{i-1}{}_{vm,ck}$) determined during the previous iteration (i-1),

a means (DC1) for determining first intervening variables ($V1^i_{vm}$) in dependence on the systematic matrix and the first determined extrinsic variables;

a means (DC2) for resolving the parity equations of the decoding window associated with the parity matrix ($H_p$) as a function of the first intervening variables and parity variables (pm) in order to obtain second intervening variables ($V2^i vm$), and

a means (DC3) for resolving the parity equations of the decoding window associated with the systematic matrix to determine second extrinsic variables ($m2^i_{vmck}$) as a function of the second intervening variables and first extrinsic variables, and

at each decoding iteration (i), a means (DC3) for assessing other data variables ($m^i_{ck}$) as a function of the data variables of the coded data signal and the second extrinsic variables determined upon processing all the decoding windows.

7. A computer program downloadable from a communication network and/or stored on a computer readable medium and/or executable by a processor, **characterised in that** it comprises instructions for implementing the decoding method according to claim 1.

# FIG. 1

# FIG. 2a

# FIG. 2b

$$H_c = \begin{bmatrix} I(1,1) & I(1,2) & -- & I(1,b) & -- & I(1,B) \\ I(2,1) & I(2,2) & -- & I(2,b) & -- & I(2,B) \\ \vdots & \vdots & & \vdots & & \vdots \\ I(a,1) & I(a,2) & -- & I(a,b) & -- & I(a,B) \\ \vdots & \vdots & & \vdots & & \vdots \\ I(A,1) & I(A,2) & -- & I(A,b) & -- & I(A,B) \end{bmatrix}$$

# FIG. 2c

$$H_p = \begin{bmatrix} I & 0 & --- & 0 & 0 & --- & Ip(1,B) \\ I & I & & & & & \\ 0 & & & & 0 & & \\ 0 & & & I & I & & 0 \\ 0 & & & & I & & 0 \\ 0 & ----- & 0 & 0 & - & 0 & I & I \end{bmatrix}$$

# FIG. 2d

$$S = \begin{bmatrix} \delta(1,1) & \delta(1,2) & -- & \delta(1,b) & -- & \delta(1,B) \\ \delta(2,1) & \delta(2,2) & -- & \delta(2,b) & -- & \delta(2,B) \\ \vdots & \vdots & & \vdots & & \vdots \\ \delta(a,1) & \delta(a,2) & -- & \delta(a,b) & -- & \delta(a,B) \\ \vdots & \vdots & & \vdots & & \vdots \\ \delta(A,1) & \delta(A,2) & -- & \delta(A,b) & -- & \delta(A,B) \end{bmatrix}$$

# FIG. 2e

# FIG. 3

DCs

MR1

Mcv $\quad$ $m1^{i}_{ck,vm}$

UC

MP $\quad$ $m^{0}_{pm}$

DC1 $\quad$ $H_c$ $\quad$ $V1^{i}$ $\quad$ DC2 $\quad$ $H_p$ $\quad$ $V2^{i}$ $\quad$ DC3 $\quad$ $H_c$

MR2

MC $\quad$ $m^{0}_{ck}, m^{i}_{ck}$

Mvc $\quad$ $m2^{i}_{vm,ck}$

MRC

S, $H_p$

# FIG. 4

DC

F1 $\qquad$ F2 $\qquad$ Fz

DC1
DC2
DC3

DC1
DC2
DC3

DC1
DC2
DC3

t

i

# FIG. 5

E1 — $i = 0$

E2 — $c1\text{-}cK,\ p1\text{-}pM$

E3 — $m^0_{c1}\text{-}m^0_{cK},\ m^0_{p1}\text{-}m^0_{pM}$

E4 — $f = 1,\ i \equiv i+1$

Ff

E5 — DC1 :
$m1^i_{ck,vm} \rightarrow MR1(Mcv)$
$v1^i_{vm}$

E6 — DC2 :
$v2^i_{vm}$

E7 — DC3 :
$m2^i_{vm,ck} \rightarrow MR2(Mvc)$

E8 — $f = z\ ?$        E9 — $f \equiv f+1$

E10 — DC3 :
$m^i_{ck} \rightarrow MR2(MC)$

E11 — $i = l\ ?$

E12 — $m^l_{c1}\text{-}m^l_{cK},\ m^l_{p1}\text{-}m^l_{pM}$

# FIG. 6

FIG. 7

FIG. 8

## FIG. 9

## FIG. 10

# FIG. 11

# FIG. 12

# FIG. 13

EP 2 092 651 B1

FIG. 14

DCpia

MR1

Mcv1 $m1^i_{ck,vm}$

Mcv2 $m1^i_{ck,vm}$

Mcv3 $m1^i_{ck,vm}$

MP

$m^0_{pm}$

DC1    DC2    DC3    UC

D11    D21    D31

D12 $V1^i$ D22 $V2^i$ D32

D1h    D2h    D3h

MR2

MC    Mvc

$m^0_{ck}, m^i_{ck}$    $m2^i_{vm,ck}$

MRC

S, $H_p$

29

# RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **MARC P. C. FOSSORIER.** Quasi-cyclic Low-Density Parity -Check Codes From Circulant Permutation Matrices. *IEEE Transaction on Information Theory,* Août 2004
- **H.JIN.** Irregular repeat-accumulate codes. *Proc. 2nd Int Symp Turbo codes and related topics,* Septembre 2000
- **KAZUNORI SHIMIZU et al.** Partially-Parallel LDPC Decoder Based on High-Efficiency Message-Passing Algorithm. *International Conference on Computer Design,* 02 Octobre 2005, 503-510

- **YANG SUN et al.** *High Throughput, parallel, scalable LDPC encoder/decoder architecture for OFDM systems*
- **FRANK KIENLE ; NORBERT WEHN.** Design methodology for IRA codes. *Proc.EDA Technofair Design Automation Conference Asia and South Pacific,* 2004